(19) Europäisches Patentamt
European Patent Office
Office européen des brevets

(11) EP 2 610 067 B1

(12) **EUROPEAN PATENT SPECIFICATION**

(45) Date of publication and mention of the grant of the patent:
**26.11.2014 Bulletin 2014/48**

(21) Application number: **11819730.0**

(22) Date of filing: **26.07.2011**

(51) Int Cl.:
***B41C 1/10*** (2006.01) ***G03F 7/033*** (2006.01)
***G03F 7/09*** (2006.01) ***G03F 7/32*** (2006.01)
***G03F 7/30*** (2006.01) ***G03F 7/11*** (2006.01)

(86) International application number:
**PCT/JP2011/067001**

(87) International publication number:
**WO 2012/026265 (01.03.2012 Gazette 2012/09)**

(54) **MASTER PLANOGRAPHIC PRINTING PLATE FOR ON-PRESS DEVELOPMENT, AND PLATE-MAKING METHOD USING SAID MASTER PLANOGRAPHIC PRINTING PLATE**

MASTER-FLACHDRUCKPLATTE FÜR ENTWICKLUNG AUF DER DRUCKPRESSE UND PLATTENHERSTELLUNGSVERFAHREN UNTER VERWENDUNG DIESER MASTER-FLACHDRUCKPLATTE

PLAQUE D’IMPRESSION PLANOGRAPHIQUE ORIGINALE PERMETTANT UN DÉVELOPPEMENT SOUS PRESSE ET PROCÉDÉ DE FABRICATION DE PLAQUE À L’AIDE DE LADITE PLAQUE D’IMPRESSION PLANOGRAPHIQUE ORIGINALE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.08.2010 JP 2010191554**

(43) Date of publication of application:
**03.07.2013 Bulletin 2013/27**

(73) Proprietor: **FUJIFILM Corporation**
**Tokyo 106-0031 (JP)**

(72) Inventor: **ISHIGURO Yuriko**
**Haibara-gun**
**Shizuoka (JP)**

(74) Representative: **Hoffmann Eitle**
**Patent- und Rechtsanwälte PartmbB**
**Arabellastraße 30**
**81925 München (DE)**

(56) References cited:
**JP-A- H11 504 436**
**JP-A- 2002 019 318**
**JP-A- 2008 225 446**
**JP-A- 2009 056 717**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 610 067 B1

## Description

TECHNICAL FIELD

The present invention relates to a lithographic printing plate precursor of on-press development type and a plate making method using the same. More particularly, it relates to a lithographic printing plate precursor of on-press development type which is capable of undergoing a direct plate making by image exposure with laser and a plate making method using the same.

BACKGROUND ART

In general, a lithographic printing plate is composed of an oleophilic image area accepting ink and a hydrophilic non-image area accepting dampening water in the process of printing. Lithographic printing is a printing method utilizing the nature of water and oily ink to repel with each other and comprising rendering the oleophilic image area of the lithographic printing plate to an ink-receptive area and the hydrophilic non-image area thereof to a dampening water-receptive area (ink-unreceptive area), thereby making a difference in adherence of the ink on the surface of the lithographic printing plate, depositing the ink only to the image area, and then transferring the ink to a printing material, for example, paper.

In order to produce the lithographic printing plate, a lithographic printing plate precursor (PS plate) comprising a hydrophilic support having provided thereon an oleophilic photosensitive resin layer (image-recording layer) is heretofore used. Specifically, the PS plate is exposed through a mask, for example, a lith film, and then subjected to development processing, for example, with an alkaline developer to remove the unnecessary image-recording layer corresponding to the non-image area by dissolving while leaving the image-recording layer corresponding to the image area, thereby obtaining the lithographic printing plate.

Due to the recent progress in the technical field, nowadays the lithographic printing plate can be obtained by a CTP (computer-to-plate) technology. Specifically, a lithographic printing plate precursor is directly subjected to scanning exposure using laser or laser diode without using a lith film and developed to obtain a lithographic printing plate.

With the progress described above, the issue on the lithographic printing plate precursor has transferred to improvements, for example, in image-forming property corresponding to the CTP technology, printing property or physical property. Also, with the increasing concern about global environment, as another issue on the lithographic printing plate precursor, an environmental problem on waste liquid discharged accompanying the wet treatment, for example, development processing comes to the front.

In response to the environmental problem, simplification of development or plate making or non-processing has been pursued. As one method of simple plate making, a method referred to as an "on-press development" is practiced. Specifically, according to the method after exposure of a lithographic printing plate precursor, the lithographic printing plate precursor is mounted as it is on a printing machine without conducting conventional development and removal of the unnecessary area of image-recording layer is performed at an early stage of printing process.

Also, as a method of simple development, a method referred to as a "gum development" is practiced in which removal of the unnecessary area of image-recording layer is performed using not a conventional highly alkaline developer but a finisher or gum solution of near-neutral pH.

In the simplification of plate making operation as described above, a system using a lithographic printing plate precursor capable of being handled in a bright room or under a yellow lamp and a light source is preferred from the standpoint of workability. Thus, as the light source, a semiconductor laser emitting an infrared ray having a wavelength of 760 to 1,200 or a solid laser, for example, YAG laser, is used. An UV laser is also used.

As the lithographic printing plate precursor capable of undergoing on-press development, for instance, a lithographic printing plate precursor having provided on a hydrophilic support, an image-recording layer (heat-sensitive layer) containing microcapsules having a polymerizable compound encapsulated therein is described in Patent Document 1 or 2. A lithographic printing plate precursor having provided on a support, an image-recording layer (photosensitive layer) containing an infrared absorbing agent, a radical polymerization initiator and a polymerizable compound is described in Patent Document 3.

It is proposed to incorporate a cellulose into an overcoat layer in order to impart ink receptivity in Patent Document 4 or 5. However, the technique is insufficient in view of balance between the ink receptivity or printing durability and the on-press development property.

Further, a lithographic printing plate precursor having provided on a support, an image-recording layer capable of being removed with either printing ink, dampening water or both of them containing an actinic radiation absorber, a polymerization initiator and a polymerizable compound and a protective layer (overcoat layer) containing an inorganic stratiform compound in this order is described in Patent Document 6.

However, the technique has a problem in that a polyvinyl alcohol resin and an inorganic stratiform compound

which has a hydrophilic surface get into the image-recording layer during the coating and drying stages and the image-recording layer is cured as it is by exposure to from the image area so that the ink receptivity is deteriorated at the initiation of printing and on the way of printing.

PRIOR ART DOCUMENT

PATENT DOCUMENT

Patent Document 1: JP-A-2001-277740
Patent Document 2: JP-A-2001-277742
Patent Document 3: JP-A-2002-287334
Patent Document 4: Japanese Patent 4162365
Patent Document 5: JP-A-2008-162056
Patent Document 6: JP-A-2005-119273

DISCLOSURE OF THE INVENTION

PROBLEMS THAT THE INVENTION IS TO SOLVE

Therefore, an object of the present invention is to provide a lithographic printing plate precursor which overcomes the problems in the prior art described above and a plate making method using the same. Specifically, it is to provide a lithographic printing plate precursor which has good on-press development property and exhibits good ink receptivity and high printing durability and a plate making method using the same.

MEANS FOR SOLVING THE PROBLEMS

The present invention includes the following items.

(1) A lithographic printing plate precursor of on-press development type comprising a support, an image-recording layer containing (A) a radical polymerization initiator, (B) a radical polymerizable compound and (C) a binder polymer having an alkylene oxide group, and an overcoat layer containing (D) a water-soluble hydroxyalkylcellulose, in this order.

(2) The lithographic printing plate precursor of on-press development type as described in (1) above, wherein the hydroxyalkylcellulose has a hydroxyalkyl structure represented by formula (1) shown below.

Formula (1)

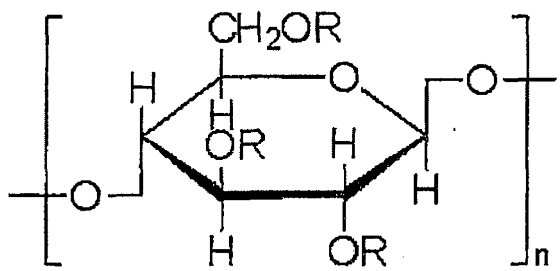

In formula (1), R represents a hydrogen atom, a methyl group or $(C_mH_{2m}O)_xH$, m represents an integer from 2 to 4, n represents an integer of 1 or more, provided that of three Rs in formula (1), a number (substitution degree) of the $(C_mH_{2m}O)_xH$ is from 0.5 to 3, and x represents an integer of 1 or more.

(3) The lithographic printing plate precursor of on-press development type as described in (2) above, wherein the $(C_mH_{2m}O)_xH$ in formula (1) is $(CH_2CH(CH_3)OH)$.

(4) The lithographic printing plate precursor of on-press development type as described in any one of (1) to (3) above, wherein the overcoat layer contains an inorganic stratiform compound.

(5) The lithographic printing plate precursor of on-press development type as described in any one of (1) to (4) above, wherein the image-recording layer contains (E) an infrared absorbing dye.

(6) A plate making method of performing on-press development processing by a method comprising exposing

imagewise the lithographic printing plate precursor of on-press development type as described in any one of (1) to (5) above, mounting the exposed lithographic printing plate precursor on a printing machine and supplying at least any of printing ink and dampening water or a method comprising mounting the lithographic printing plate precursor as described in any one of (1) to (5) above on a printing machine, exposing imagewise the lithographic printing plate precursor and supplying at least any of printing ink and dampening water.

According to the present invention, a lithographic printing plate precursor excellent in the ink receptivity and printing durability without accompanying deterioration of the on-press development property can be obtained by combining the image-recording layer containing a binder polymer having an alkylene oxide group with the overcoat layer containing a hydroxyalkylcellulose.

The functional mechanism thereof according to the invention is not quite clear but it is believed as follows.

Heretofore, at the coating and drying of a coating solution for overcoat layer, "interlayer mixing of image-recording layer/ overcoat layer" in which a water-soluble resin or an inorganic stratiform compound when it is present in the overcoat layer is mixed with components of image-recording layer occurs and thus, smooth dissolution and removal of the overcoat layer is disturbed at the time of on-press development to cause deterioration of on-press development property and ink receptivity.

It is believed that the improvement in on-press development property according to the invention is caused by acceleration of the on-press development property by using a binder polymer having an alkylene oxide group in the image-recording layer and inhibition of the interlayer mixing by incorporating a hydroxyalkylcellulose which is difficult to be mixed with the components of image-recording layer into the overcoat layer. Also, it is believed to be the effect due to the inhibition of the interlayer mixing described above that even when an inorganic stratiform compound which causes improvement in the printing durability is added to the overcoat layer, the degradation of ink receptivity which has heretofore been a problem does not occur and good ink receptivity is obtained.

As described above, the lithographic printing plate precursor excellent in the ink receptivity and printing durability without accompanying deterioration of the on-press development property can be obtained by the effect due to the combination of the image-recording layer containing a binder polymer having an alkylene oxide group with the overcoat layer containing a hydroxyalkylcellulose according to the invention.

ADVANTAGE OF THE INVENTION

According to the invention, a lithographic printing plate precursor which has good on-press development property and exhibits high printing durability and good ink receptivity and a plate making method using the same are provided.

MODE FOR CARRYING OUT THE INVENTION

The present invention will be described in detail below.

[Lithographic printing plate precursor]

The lithographic printing plate precursor according to the invention comprises an image-recording layer containing (A) a radical polymerization initiator, (B) a radical polymerizable compound and (C) a binder polymer having an alkylene oxide group, and an overcoat layer containing (D) a water-soluble hydroxyalkylcellulose, in this order. Thus the lithographic printing plate precursor can has the good on-press development property, high printing durability and good ink receptivity.

Further, the lithographic printing plate precursor according to the invention may have an undercoat layer between the support and the image-recording layer in some cases.

Hereinafter, the constituting elements, components and the like of the lithographic printing plate precursor according to the invention will be described.

First, the overcoat layer which is the characterizing part of the lithographic printing plate precursor according to the invention is described. [Overcoat layer]

The lithographic printing plate precursor according to the invention is characterized by having an overcoat layer containing (D) a water-soluble hydroxyalkylcellulose on the image-recoding layer. The overcoat layer has a function for preventing, for example, occurrence of scratch in the image-recording layer or ablation caused by exposure with a high illuminance laser beam, in addition to the function for restraining an inhibition reaction against the image formation by means of oxygen blocking.

(D) Water-soluble hydroxyalkylcellulose

The water-soluble hydroxyalkylcellulose which can be used in the invention is preferably a hydroxyalkylcellulose represented by formula (1) shown below.

Formula (1)

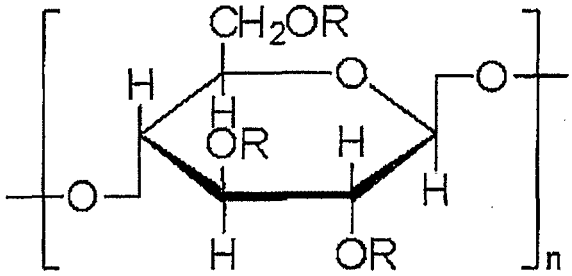

In formula (1), R represents a hydrogen atom, a methyl group or $(C_mH_{2m}O)_xH$, m represents an integer from 2 to 4, n represents an integer of 1 or more, provided that of three Rs in formula (1), a number (substitution degree) of the $(C_mH_{2m}O)_xH$ is from 0.5 to 3, and x represents an integer of 1 or more.
Specifically, a resin obtained by making cellulose water-soluble, for example, hydroxyethylcellulose, hydroxypropylcellulose (HPC or the like), hydroxyethylmethylcellulose, hydroxypropylmethylcellulose or a modified product thereof is preferred. They may be used individually or in combination. Among them, a particularly preferred water-soluble cellulose is hydroxypropylcellulose which is a compound represented by formula (1) wherein the $(C_mH_{2m}O)_xH$ is $(CH_2CH(CH_3)OH)$. A number of the substituted groups (substitution degree) of three hydroxy groups present on the six-membered ring of cellulose is preferably from 0.5 to 3.0, more preferably from 0.6 to 2.5, and particularly preferably from 1.0 to 2.5.
It is preferred to incorporate the hydroxyalkylcellulose in an amount of 40% by weight or more of the overcoat layer. When the amount is 40% by weight or more, the ink receptivity is preferably more increased. The amount thereof is more preferably 60% by weight or more, and particularly preferably 80% by weight or more.
The viscosity (aqueous 2% by weight solution/20°C/B type viscometer) of the resin is preferably from 1 to 4,000 mPa·s, more preferably from 2 to 400 mPa·s, and most preferably from 2 to 150 mPa·s. In the range described above, the development property is preferably more increased.
To the overcoat layer, a water-soluble resin different from the hydroxyalkylcellulose can also be added for the purpose of increasing the development property. Specific examples thereof include polyvinyl acetate (having hydrolysis degree of 65% or more), polyacrylic acid and its alkali metal salt or its amine salt, a polyacrylic acid copolymer and its alkali metal salt or its amine salt, a polymethacrylic acid and its alkali metal salt or its amine salt, a polymethacrylic acid copolymer and its alkali metal salt or its amine salt, a polyacrylamide and its copolymer, polyhydroxyethyl acrylate, polyvinylpyrrolidone and its copolymer, polyvinyl methyl ether, vinyl methyl ether/maleic anhydride copolymer, poly-2-acrylamido-2-methyl-1-propanesulfonic acid and its alkali metal salt or its amine salt, a 2-acrylamido-2-methyl-1-propanesulfonic acid copolymer and its alkali metal salt or its amine salt, gum arabic, white dextrin, pullulan and enzyme-decomposed etherified dextrin. The polyacrylamide and its copolymer or polyvinyl acetate is preferred. The water-soluble resin different from the hydroxyalkylcellulose can be added in an amount less than 40% by weigh as to the overcoat layer. When the amount is less than 40% by weigh, the ink receptivity is preferably good. The amount thereof is more preferably less than 30% by weigh, and still more preferably less than 20% by weigh.

(E) Inorganic stratiform compound

The overcoat layer of the lithographic printing plate precursor according to the invention may contain an inorganic stratiform compound.
The inorganic stratiform compound is a particle having a thin tabular shape and includes, for instance, mica, for example, natural mica represented by the following formula: A $(B, C)_{2-5}$ $D_4$ $O_{10}$ $(OH, F, O)_2$, (wherein A represents any of Li, K, Na, Ca, Mg and an organic cation, B and C each represents any of Fe(II), Fe(III), Mn, Al, Mg and V, and D represents Si or Al) or synthetic mica, talc represented by the following formula: $3MgO \cdot 4SiO \cdot H_2O$, taeniolite, montmorillonite, saponite, hectorite and zirconium phosphate.
Examples of the natural mica include muscovite, paragonite, phlogopite, biotite and lepidolite. Examples of the synthetic mica include non-swellable mica, for example, fluorphlogopite $KMg_3(AlSi_3O_{10})F_2$ or potassium tetrasilicic mica $(KMg_{2.5}Si_4O_{10})F_2$, and swellable mica, for example, Na tetrasilicic mica $NaMg_{2.5}(Si_4O_{10})F_2$, Na or Li taeniolite (Na,

Li)$Mg_2Li(Si_4O_{10})F_2$, or montmorillonite-based Na or Li hectorite $(Na, Li)_{1/8}Mg_{2/5}Li_{1/8}(S_4O_{10})F_2$. Further, synthetic smectite is also useful.

Of the inorganic stratiform compounds, mica is preferred and fluorine-based swellable mica, which is a synthetic inorganic stratiform compound, is particularly useful. Specifically, the swellable synthetic mica and a swellable clay mineral, for example, montmorillonite, saponite, hectorite or bentonite have a laminate structure comprising a unit crystal lattice layer having a thickness of approximately from 10 to 15 angstroms, and metallic atom substitution in the lattices thereof is remarkably large in comparison with other clay minerals. As a result, the lattice layer results in lack of positive charge and to compensate it, a cation, for example, $Li^+$, $Na^+$, $Ca^{2+}$, $Mg^{2+}$ or an organic cation is adsorbed between the lattice layers. The inorganic stratiform compound swells upon contact with water. When share is applied under such condition, the stratiform crystal lattices are easily cleaved to form a stable sol in water. The bentnite and swellable synthetic mica have strongly such tendency.

As to the shape of the inorganic stratiform compound, from the standpoint of control of diffusion, the thinner the thickness or the larger the plain size as long as smoothness of coated surface and transmission of actinic radiation are not damaged, the better. Therefore, an aspect ratio of the inorganic stratiform compound is preferably 20 or more, more preferably 100 or more, and particularly preferably 200 or more. The aspect ratio is a ratio of thickness to major axis of particle and can be determined, for example, from a projection drawing of particle by a microphotography. The larger the aspect ratio, the greater the effect obtained.

As to a particle diameter of the inorganic stratiform compound, an average diameter thereof is preferably from 1 to 20 μm, more preferably from I to 10 μm, and particularly preferably from 2 to 5 μm. When the particle diameter is 1 μm or more, the inhibition of permeation of oxygen or moisture is preferably sufficient. On the other hand, when it is 20 μm or less, the dispersion stability of the particle in the coating solution is sufficient so that the stable coating can be preferably conducted. An average thickness of the particle is 0.1 μm or less, preferably 0.05 μm or less, and particularly preferably 0.01 μm or less. For example, with respect to the swellable synthetic mica that is the representative compound of the inorganic stratiform compound, the thickness is preferably approximately from 1 to 50 nm and the plain size is preferably approximately from 1 to 20 μm.

When such an inorganic stratiform compound particle having a large aspect ratio is incorporated into the overcoat layer, strength of the coated layer increases and penetration of oxygen or moisture can be effectively inhibited and thus, the overcoat layer can be prevented from deterioration due to deformation, and even when the lithographic printing plate precursor is preserved for a long period of time under a high humidity condition, it is prevented from decrease in the image-forming property of the lithographic printing plate precursor due to the change of humidity and the effect of excellent preservation stability can be obtained.

Further, a fluorine-based compound, a silicone-based compound or a wax agent emulsion can be added to the overcoat layer in order to prevent tackiness. When such a compound is added, the compound moves to the surface of the overcoat layer so that the tackiness resulting from the hydrophilic polymer disappears. The amount of the compound added is preferably from 0.1 to 5% by weight, more preferably from 0.5 to 2.0% by weight, of the overcoat layer.

To the coating solution for overcoat layer can be added known additives, for example, an anionic surfactant, a nonionic surfactant, a cationic surfactant or a fluorine-based surfactant for improving the coating property or a water-soluble plasticizer for improving the physical property of the overcoat layer. Examples of the water-soluble plasticizer include propionamide, cyclohexane diol, glycerin and sorbitol. Further, to the coating solution for overcoat layer may be added known additives for improving properties, for example, adhesion property to the image-recording layer, preservation stability of the coating solution or ink receptivity.

The overcoat layer can be coated on the image-recording layer by a known method. The coating amount of the overcoat layer is preferably in a range form 0.01 to 10 $g/m^2$, more preferably in a range from 0.02 to 3 $g/m^2$, most preferably in a range from 0.02 to 1 $g/m^2$, in terms of the coating amount after drying.

[Image-recording layer]

(C) Binder polymer having alkylene oxide group

The binder polymer having an alkylene oxide group which can be used in the lithographic printing plate precursor according to the invention may have a poly(alkylene oxide) moiety in the main chain thereof or in the side chain thereof, or may be a graft polymer having a poly(alkylene oxide) in its side chain or a block copolymer composed of a block constituted by a repeating unit containing a poly(alkylene oxide) and a block constituted by a repeating unit not containing an (alkylene oxide).

In the case where the alkylene oxide group is present in the main chain, a polyurethane resin is preferred. In the case where the alkylene oxide group is present in the side chain, a polymer constituting its main chain includes an acrylic resin, a polyvinyl acetal resin, a polyurethane resin, a polyurea resin, a polyimide resin, a polyamide resin, an epoxy resin, a methacrylic resin, a polystyrene resin, a novolac type phenolic resin, a polyester resin, a synthesis rubber

and a natural rubber. In particular, an acrylic resin is preferred.

The alkylene oxide is preferably an alkylene oxide having from 2 to 6 carbon atoms, and particularly preferably an ethylene oxide or a propylene oxide.

A repeating number of alkylene oxide in the poly(alkylene oxide) moiety is preferably from 2 to 120, more preferably in a range from 2 to 70, and still more preferably in a range from 2 to 50.

It is preferred that the repeating number of alkylene oxide is 120 or less because both the printing durability as to abrasion and the printing durability as to ink receptivity are improved.

The poly(alkylene oxide) moiety is preferably introduced into an side chain of the binder as a structure represented by formula (2) shown below. More preferably, it is introduced into a side chain of an acrylic resin as a structure represented by formula (2) shown below.

Formula (2)

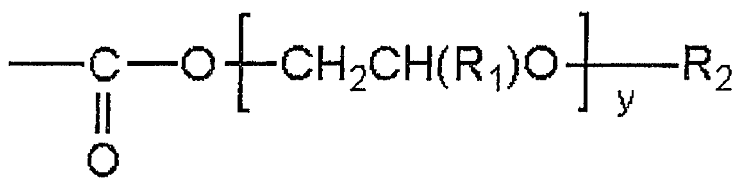

In formula (2), y represents a number from 2 to 120, preferably in a range from 2 to 70, and more preferably in a range from 2 to 50. $R_1$ represents a hydrogen atom or an alkyl group. $R_2$ represents a hydrogen atom or an organic group. The organic group is preferably an alkyl group having from 1 to 6 carbon atoms and includes a methyl group, an ethyl group, an n-propyl group, an isopropyl group, an n-butyl group, a sec-butyl group, an isobutyl group, a tert-butyl group, an n-pentyl group, an isopentyl group, a neopentyl group, an n-hexyl group, an isohexyl group, a 1,1-dimethylbutyl group, a 2,2-dimethylbutyl group, a cyclopentyl group and a cyclohexyl group.

In formula (2), $R_1$ is preferably a hydrogen atom or a methyl group and most preferably a hydrogen atom. $R_2$ is most preferably a hydrogen atom or a methyl group.

The binder polymer may have a crosslinking property in order to improve the film strength of the image area. In order to impart the crosslinking property to the binder polymer, a crosslinkable functional group, for example, an ethylenically unsaturated bond is introduced into a main chain or side chain of the polymer. The crosslinkable functional group may be introduced by copolymerization.

Examples of the polymer having an ethylenically unsaturated bond in the main chain thereof include poly-1,4-butadiene and poly-1,4-isoprene.

Examples of the polymer having an ethylenically unsaturated bond in the side chain thereof include a polymer of an ester or amide of acrylic acid or methacrylic acid, which is a polymer wherein the ester or amido residue (R in -COOR or -CONHR) has an ethylenically unsaturated bond.

Examples of the residue (R described above) having an ethylenically unsaturated bond include $-(CH_2)_nCR^1=CR^2R^3$, $-(CH_2O)_nCH_2CR^1=CR^2R^3$, $-(CH_2CH_2O)_nCH_2CR^1=CR^2R^3$, $-(CH_2)_nNH-CO-O-CH_2CR^1=CR^2R^3$, $-(CH_2)_n-O-CO-CR^1=CR^2R^3$ and $-(CH_2CH_2O)_2-X$ (wherein $R^1$ to $R^3$ each represents a hydrogen atom, a halogen atom or an alkyl group having from 1 to 20 carbon atoms, an aryl group, an alkoxy group or an aryloxy group, or $R^1$and $R^2$ or $R^1$ and $R^3$ may be combined with each other to form a ring. n represents an integer from 1 to 10. X represents a dicyclopentadienyl residue).

Specific examples of the ester residue include $-CH_2CH=CH_2$ (described in JP-B-7-21633), $-CH_2CH_2O-CH_2CH=CH_2$, $-CH_2C(CH_3)=CH_2$, $-CH_2CH=CH-C_6H_5$; $-CH_2CH_2OCOCH=CH-C_6H_5$, $-CH_2CH_2-NHCOO-CH_2CH=CH_2$ and $-CH_2CH_2O-X$ (wherein X represents a dicyclopentadienyl residue).

Specific examples of the amido residue include $-CH_2CH=CH_2$, $-CH_2CH_2-Y$ (wherein Y represents a cyclohexene residue) and $-CH_2CH_2-OCO-CH=CH_2$.

The binder polymer having crosslinkable property is cured, for example, by addition of a free radical (a polymerization initiating radical or a growing radical of a polymerizable compound in the process of polymerization) to the crosslinkable functional group of the polymer and undergoing addition polymerization between the polymers directly or through a polymerization chain of the polymerizable compound to form crosslinkage between the polymer molecules. Alternately, it is cured by generation of a polymer radical upon extraction of an atom (for example, a hydrogen atom on a carbon atom adjacent to the functional crosslinkable group) in the polymer by a free radial and connecting the polymer radicals with each other to form cross-linkage between the polymer molecules.

The content of the crosslinkable group (content of the radical polymerizable unsaturated double bond determined by iodine titration) in the binder polymer is preferably from 0.1 to 10.0 mmol, more preferably from 1.0 to 7.0 mmol, most preferably from 2.0 to 5.5 mmol, based on 1 g of the polymer. In the range described above, good sensitivity and good

preservation stability can be obtained.

Specific examples (1) to (11) of the binder polymer which can be used in the invention are set forth below, but the invention should not be construed as being limited thereto.

(1) 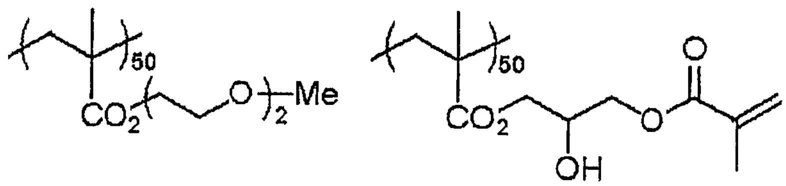

(2) 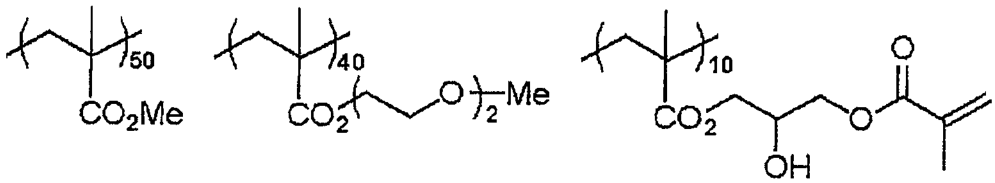

(3) 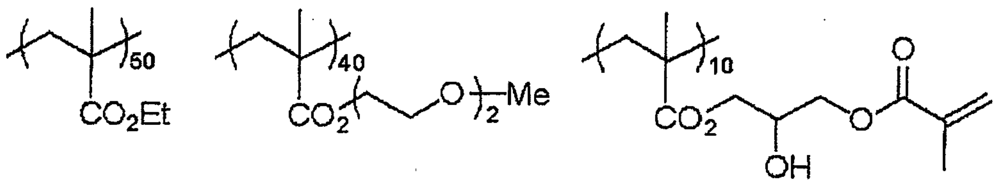

(4) 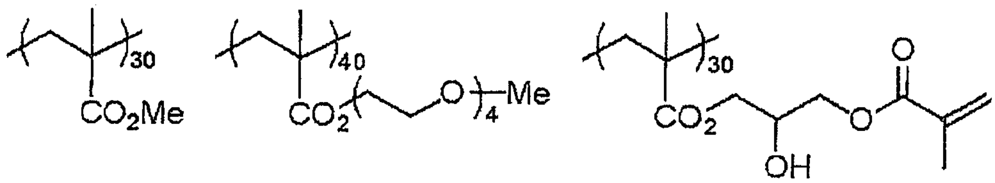

(5) 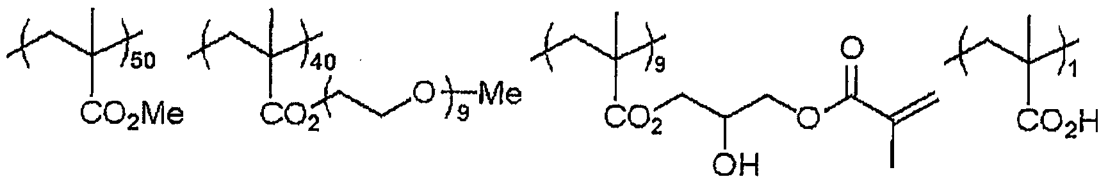

(6) 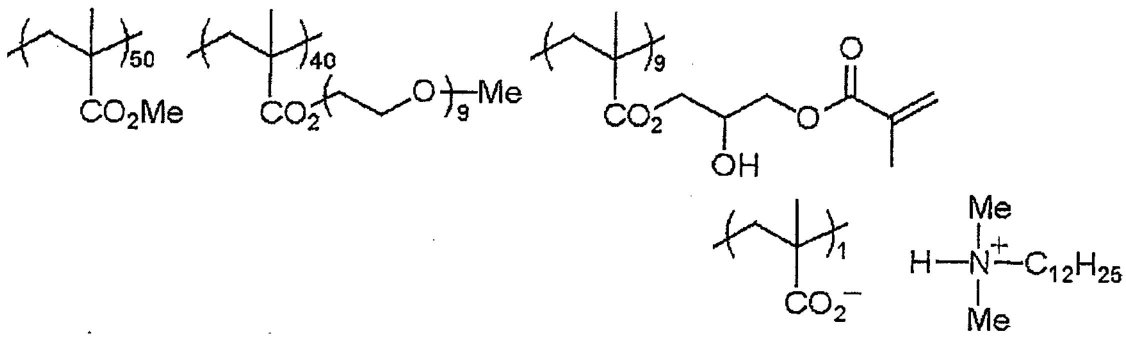

(7) 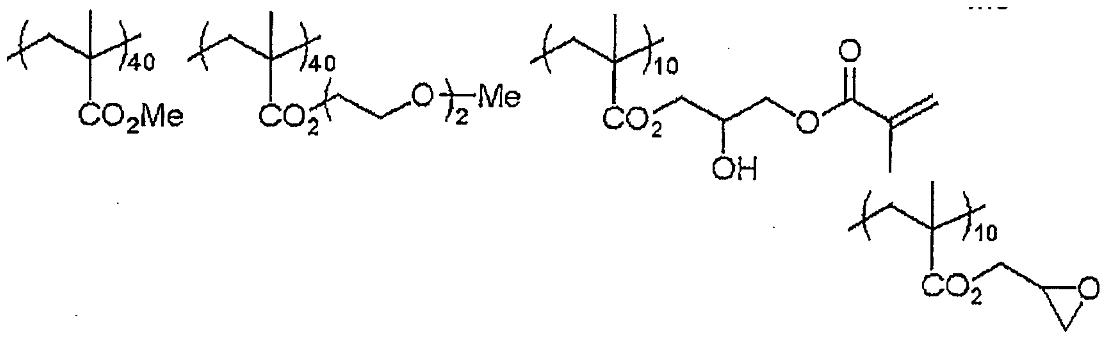

(8) 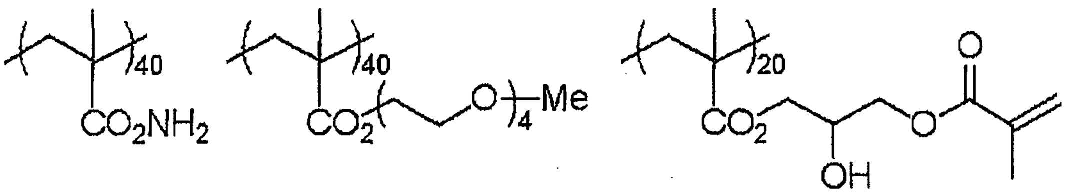

(9) 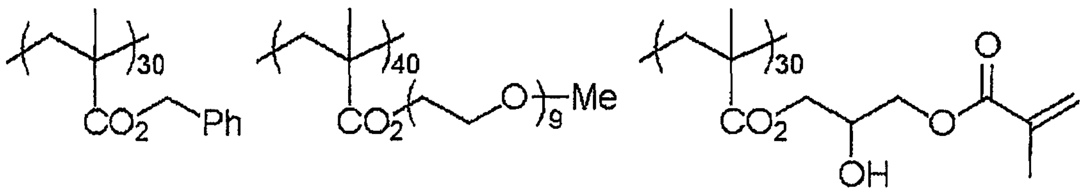

(10) 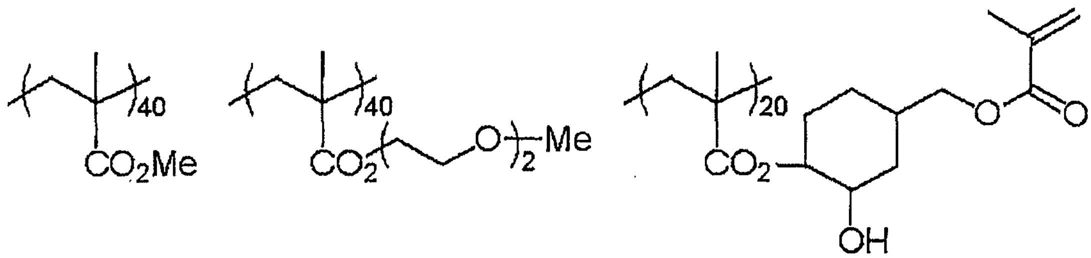

(11) 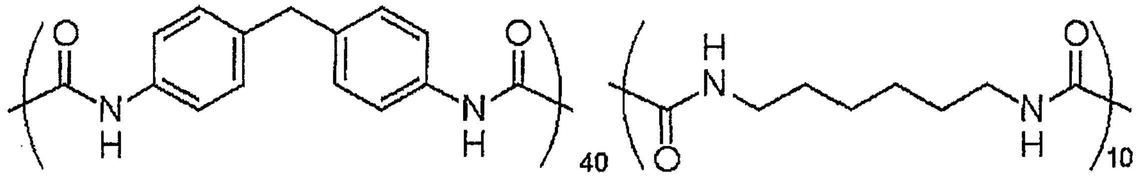

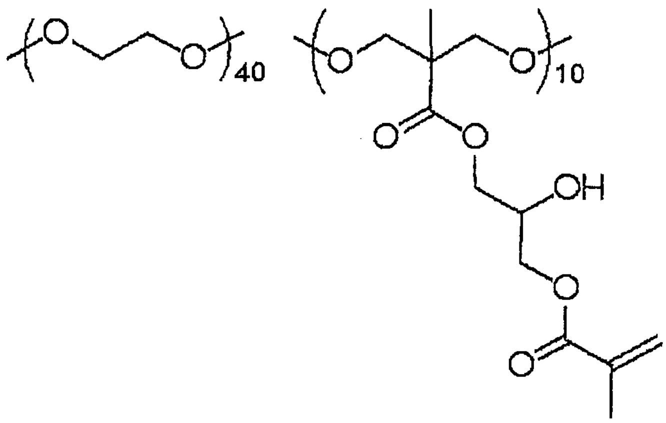

The weight average molecular weight (Mw) of the binder polymer according to the invention is preferably 2,000 or more, more preferably 5,000 or more, and still more preferably from 10,000 to 300,000.
According to the invention, a hydrophilic polymer compound, for example, polyacrylic acid or polyvinyl alcohol described in JP-A-2008-195018 may be used together, if desired. Further, an oleophilic polymer compound may be used in combination with a hydrophilic polymer compound.
As to the configuration of the binder polymer according to the invention, it may be present as a binder acting as a bond of each ingredient or in the form of fine particle in the image-recording layer. In the case of existing in the form of fine particle, the average particle size thereof is preferably in a range from 10 to 1,000 nm, more preferably in a range from 20 to 300 nm, and particularly preferably in a range from 30 to 120 nm.
The content of the binder polymer according to the invention is preferably from 5 to 90% by weight, more preferably from 5 to 80% by weight, still more preferably from 10 to 70% by weight, based on the total solid content of the image-recording layer.
Next, constituting components of the image-recording layer other than the binder polymer having an alkylene oxide group (C) are described in detail below.
The image-recording layer which can be used in the invention is an image-recording layer capable of undergoing on-press development. As a representative image-forming embodiment included in the image-recording layer capable of undergoing on-press development, (1) an embodiment which contains (A) a radical polymerization initiator, (B) a radical polymerizable compound and (E) an infrared absorbing dye and in which the image area is cured utilizing a polymerization reaction, and (2) an embodiment which contains (E) an infrared absorbing dye and (F) a hydrophobilizing precursor and in which a hydrophobic region (image area) is formed utilizing heat fusion or a heat reaction of the hydrophobilizing precursor are exemplified. Also, a mixture of the above-described two embodiments may be used. For example, the hydrophobilizing precursor (F) may be incorporated into the image-recording layer of polymerization type (1) or the radical polymerizable compound (B) or the like may be incorporated into the image-recording layer of hydrophobilizing precursor type (2). Among them, the embodiment of polymerization type which contains (A) a radical polymerization initiator, (B) a radical polymerizable compound and (E) an infrared absorbing dye is preferred.
Respective components which can be incorporated into the image-recording layer are described in order below.

(A) Radical polymerization initiator

The radical polymerization initiator (A) which can be used in the invention indicates a compound which initiates or accelerates polymerization of the radical polymerizable compound (B). The radical polymerization initiator usable in the invention includes, for example, known thermal polymerization initiators, compounds containing a bond having small bond dissociation energy and photopolymerization initiators.
The radical polymerization initiator according to the invention include, for example, (a) an organic halide, (b) a carbonyl compound, (c) an azo compound, (d) an organic peroxide, (e) a metallocene compound, (f) an azide compound, (g) a hexaarylbiimidazole compound, (h) an organic borate compound, (i) a disulfone compound, (j) an oxime ester compound and (k) an onium salt compound.
As the organic halide (a), compounds described in Paragraph Nos. [0022] to [0023] of JP-A-2008-195018 are preferred.
As the carbonyl compound (b), compounds described in Paragraph No. [0024] of JP-A-2008-195018 are preferred.
As the azo compound (c), for example, azo compounds described in JP-A-8-108621 can be used.
As the organic peroxide (d), for example, compounds described in Paragraph No. [0025] of JP-A-2008-195018

are preferred.

As the metallocene compound (e), for example, compounds described in Paragraph No. [0026] of JP-A-2008-195018 are preferred.

As the azide compound (f), a compound, for example, 2,6-bis(4-azidobenzylidene)-4-methylcyclohexanone is exemplified.

As the hexaarylbiimidazole compound (g), for example, compounds described in Paragraph No. [0027] of JP-A-2008-195018 are preferred.

As the organic borate compound (h), for example, compounds described in Paragraph No. [0028] of JP-A-2008-19501 are preferred.

As the disulfone compound (i), for example, compounds described in JP-A-61-166544 are exemplified.

As the oxime ester compound (j), for example, compounds described in Paragraph Nos. [0028] to [0030] of JP-A-2008-195018 are preferred.

As the onium salt compound (k), onium salts, for example, diazonium salts described in S. I. Schlesinger, Photogr. Sci. Eng., 18, 387 (1974), T. S. Bal et al., Polymer, 21, 423 (1980) and JP-A-5-158230 (corresponding to diazonium of NI3), ammonium salts described in U.S. Patent 4,069,055 and JP-A-4-365049, phosphonium salts described in U.S. Patents 4,069,055 and 4,069,056, iodonium salts described in European Patent 104,143, U. S. Patent Publication No. 2008/0311520, JP-A-2-150848, JP-A-2008-195018 and J. V. Crivello et al., Macromolecules, 10 (6), 1307 (1977), sulfonium salts described in European Patents 370,693, 233,567, 297,443 and 297,442, U.S. Patents 4,933,377, 4,760,013, 4,734,444 and 2,833,827 and German Patents 2,904,626, 3,604,580 and 3,604,581, selenonium salts described in J. V. Crivello et al., J. Polymer Sci., Polymer Chem. Ed., 17, 1047 (1979), arsonium salts described in C. S. Wen et al., Teh, Proc. Conf. Rad. Curing ASIA, p. 478, Tokyo, Oct. (1988), and azinium salts described in JP-A-2008-195018 are exemplified.

Of the radical polymerization initiators described above, the onium salt, in particular, the iodonium salt, the sulfonium salt or the azinium salt is more preferred. Specific examples of these compounds are set forth below, but the invention should not be construed as being limited thereto.

Of the iodonium salts, a diphenyliodonium salt is preferred. In particular, a diphenyliodonium salt substituted with an electron donating group, for example, an alkyl group or an alkoxy group is preferred, and an asymmetric diphenyliodonium salt is more preferred. Specific examples of the iodonium salt include diphenyliodonium hexafluorophosphate, 4-methoxyphenyl-4-(2-methylpropyl)phenyliodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorobutanesulfonate, 4-octyloxyphenyl-2,4,6-trimethoxyphenyliodonium hexafluorophosphate and bis(4-tert-butylphenyl)iodonium tetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate, tis(4-chlorophenyl)sulfonium 3,5-bis(methoxycarbonyl)benzenesulfonate and tris(4-chlorophenyl)sulfonium hexafluorophosphate.

Examples of the azinium salt include 1-cyclohexylmethyloxypyridinium hexafluorophosphate, 1-cyclohexyloxy-4-phenylpyridinium hexafluorophosphate, 1-ethoxy-4-phenylpyridinium hexafluorophosphate, 1-(2-ethylhexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridinium hexafluorophosphate, 1-benzyloxy-4-phenylpyridinium hexafluorophosphate, 1-phenethyloxy-4-phenylpyridinium hexafluorophosphate, 1-(2-ethylhexyloxy)-4-phenylpyridinium p-toluenesulfonate, 1-(2-ethylhexyloxy)-4-phenylpyridinium perfluorobutanesulfonate, 1-(2-ethylhexyloxy)-4-phenylpyridinium bromide and 1-(2-ethylhexyloxy)-4-phenylpyridinium tetrafluoroborate.

The radical polymerization initiator can be added preferably in an amount from 0.1 to 50% by weight, more preferably from 0.5 to 30% by weight, particularly preferably from 0.8 to 20% by weight, based on the total solid content constituting the image-recording layer. In the range described above, good sensitivity and good stain resistance in the non-image area at the time of printing are obtained.

(B) Radical polymerizable compound

The radical polymerizable compound for use in the image-recording layer according to the invention is an addition-polymerizable compound having at least one ethylenically unsaturated double bond and it is selected from compounds having at least one, preferably two or more, terminal ethylenically unsaturated double bonds. The radical polymerizable compound has a chemical form, for example, a monomer, a prepolymer, specifically, a dimer, a trimer or an oligomer, or a mixture thereof.

Examples of the monomer include an unsaturated carboxylic acid (for example, acrylic acid, methacrylic acid, itaconic acid, crotonic acid, isocrotonic acid or maleic acid) and an ester or amide thereof. Preferably, an ester of an

unsaturated carboxylic acid with a polyhydric alcohol compound and an amide of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of an unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen group or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used. These compounds are described in references including JP-T-2006-508380, JP-A-2002-287344, JP-A-2008-256850, JP-A-2001-342222, JP-A-9-179296, JP-A-9-179297, JP-A-9-179298, JP-A-2004-294935, JP-A-2006-243493, JP-A-2002-275129, JP-A-2003-64130, JP-A-2003-280187 and JP-A-10-333321.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyethoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

$$CH_2=C(R^4)COOCH_2CH(R^5)OH \qquad (A)$$

wherein $R^4$ and $R^5$ each independently represents H or $CH_3$.

Also, urethane acrylates as described in JP-A-51-37193, JP-B-2-32293, JP-B-2-16765, JP-A-2003-344997 and JP-A-2006-65210, urethane compounds having an ethylene oxide skeleton described in JP-B-58-49860, JP-B-56-17654, JP-B-62-39417, JP-B-62-39418, JP-A-2000-250211 and JP-A-2007-94138, and urethane compounds having a hydrophilic group described in U.S. Patent 7,153,632, JP-T-8-505958, JP-A-2007-293221 and JP-A-2007-293223 are preferably used.

Of the compounds described above, an isocyanuric acid ethyleneoxide-modified acrylate, for example, tris(acryloyloxyethyl) isocyanurate or bis(acryloyloxyethyl) hydroxyethyl isocyanurate is particularly preferred from the standpoint of excellent balance between hydrophilicity relating to the on-press development property and polymerization ability relating to the printing durability.

Details of the method of using the polymerizable compound, for example, selection of the structure, individual or combination use or an amount added, can be appropriately determined in accordance with the characteristic design of the final lithographic printing plate precursor. The polymerizable compound is used preferably in a range from 5 to 75% by weight, more preferably in a range from 10 to 70% by weight, particularly preferably in a range from 15 to 60% by weight, based on the total solid content of the image-recording layer.

(E) Infrared absorbing dye

The infrared absorbing dye has a function of converting the infrared ray absorbed to heat and a function of being excited by the infrared ray to perform electron transfer and/or energy transfer to the radical polymerization initiator described above. The infrared absorbing dye for use in the invention includes a dye having an absorption maximum in a wavelength range from 760 to 1,200 nm.

As the dye, commercially available dyes and known dyes described in literatures, for example, Senryo Binran, compiled by The Society of Synthetic Organic Chemistry, Japan (1970) can be used. Specifically, the dye includes an azo dye, a metal complex azo dye, a pyrazolone azo dye, a naphthoquinone dye, an anthraquinone dye, a phthalocyanine

dye, a carbonium dye, a quinoneimine dye, a methine dye, a cyanine dye, a squarylium dye, a pyrylium salt and a metal thiolate complex.

Of the dyes, a cyanine dye, a squarylium dye, a pyrylium salt, a nickel thiolate complex or an indolenine cyanine dye is particularly preferred. A cyanine dye or an indolenine cyanine dye is more preferred. As a particularly preferred example of the dye, a cyanine dye represented by formula (a) shown below is exemplified.

Formula (a)

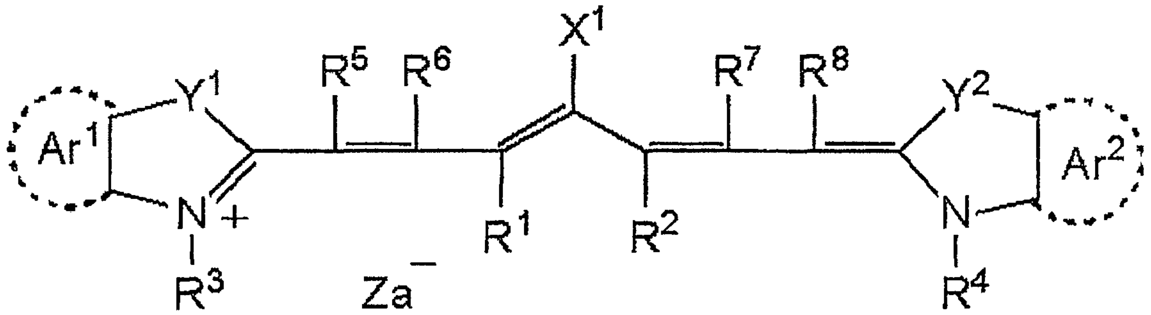

In formula (a), $X^1$ represents a hydrogen atom, a halogen atom, $-N(R^9)(R^{10})$, $-X^2-L^1$ or a group shown below. $R^9$ and $R^{10}$, which may be the same or different, each represents an aromatic hydrocarbon group having from 6 to 10 carbon atoms which may have a substituent, an alkyl group having from 1 to 8 carbon atoms which may have a substituent or a hydrogen atom, or $R^9$ and $R^{10}$ may be combined with each other to form a ring. $R^9$ and $R^{10}$ each preferably represents a phenyl group. $X^2$ represents an oxygen atom or a sulfur atom. $L^1$ represents a hydrocarbon group having from 1 to 12 carbon atoms, an aromatic ring group containing a hetero atom or a hydrocarbon group having from 1 to 12 carbon atoms and containing a hetero atom. The hetero atom used herein indicates a nitrogen atom, a sulfur atom, an oxygen atom, a halogen atom or a selenium atom. In the group shown below, $Xa^-$ has the same meaning as $Za^-$ defined hereinafter. $R^a$ represents a hydrogen atom or a substituent selected from an alkyl group, an aryl group, a substituted or unsubstituted amino group and a halogen atom.

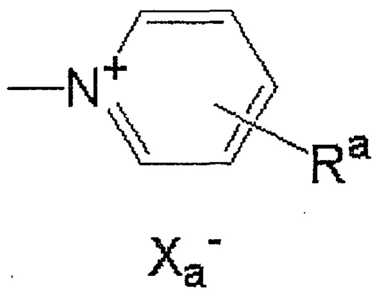

$R^1$ and $R^2$ each independently represents a hydrocarbon group having from 1 to 12 carbon atoms. In view of the preservation stability of a coating solution for image-recording layer, it is preferred that $R^1$ and $R^2$ each represents a hydrocarbon group having two or more carbon atoms. Alternatively, $R^1$ and $R^2$ may be combined with each other to form a ring and in the case of forming a ring, it is particularly preferred that $R^1$ and $R^2$ are combined with each other to form a 5-membered or 6-membered ring.

$Ar^1$ and $Ar^2$, which may be the same or different, each represents an aryl group which may have a substituent. Preferred examples of the aryl group include a benzene ring group and a naphthalene ring group. Preferred examples of the substituent include a hydrocarbon group having 12 or less carbon atoms, a halogen atom and an alkoxy group having 12 or less carbon atoms. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms which may have a substituent. Preferred examples of the substituent include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. In view of the availability of raw materials, a hydrogen atom is preferred. $Za^-$ represents a counter anion. However, $Za^-$ is not necessary when the cyanine dye represented by formula (a) has an anionic substituent in the structure thereof and neutralization of charge is not needed. Preferred examples of the counter ion for $Za^-$ include a halide ion, a perchlorate ion, a tetrafluoroborate ion, a hexafluorophosphate ion and a sulfonate ion, and particularly preferred examples thereof

include a perchlorate ion, a hexafluorophosphate ion and an arylsulfonate ion in view of the preservation stability of a coating solution for image-recording layer.

Specific examples of the cyanine dye represented by formula (a), which can be preferably used in the invention, include compounds described in Paragraph Nos. [0017] to [0019] of JP-A-2001-133969, Paragraph Nos. [0012] to [0021] of JP-A-2002-23360 and Paragraph Nos. [0012] to [0037] of JP-A-2002-40638, preferably compounds described in Paragraph Nos. [0034] to [0041] of JP-A-2002-278057 and Paragraph Nos. [0080] to [0086] of JP-A-2008-195018, and most preferably compounds described in Paragraph Nos. [0035] to [0043] of JP-A-2007-90850.

Also, compounds described in Paragraph Nos. [0008] to [0009] of JP-A-5-5005 and Paragraph Nos. [0022] to [0025] of JP-A-2001-222101 are preferably used.

The infrared absorbing dyes (B) may be used only one kind or in combination of two or more kinds thereof and it may also be used together with an infrared absorbing agent other than the infrared absorbing dye, for example, a pigment. As the pigment, compounds described in Paragraph Nos. [0072] to [0076] of JP-A-2008-195018 are preferred.

The content of the infrared absorbing dye in the image-recording layer according to the invention is preferably from 0.1 to 10.0% by weight, more preferably from 0.5 to 5.0% by weight, based on the total solid content of the image-recording layer.

(F) Hydrophobilizing precursor

In the invention, a hydrophobilizing precursor can be used in order to improve the on-press development property. The hydrophobilizing precursor according to the invention means a fine particle capable of converting the image-recording layer to be hydrophobic when heat is applied. The fine particle is preferably at least one fine particle selected from hydrophobic thermoplastic polymer fine particle, thermo-reactive polymer fine particle, polymer fine particle having a polymerizable group, microcapsule having a hydrophobic compound encapsulated and microgel (crosslinked polymer fine particle). Among them, polymer fine particle having a polymerizable group and microgel are preferred.

As the hydrophobic thermoplastic polymer fine particle, hydrophobic thermoplastic polymer fine particles described, for example, in Research Disclosure, No. 333003, January (1992), JP-A-9-123387, JP-A-9-131850, JP-A-9-171249, JP-A-9-171250 and European Patent 931,647 are preferably exemplified.

Specific examples of the polymer constituting the polymer fine particle include a homopolymer or copolymer of a monomer, for example, ethylene, styrene, vinyl chloride, methyl acrylate, ethyl acrylate, methyl methacrylate, ethyl methacrylate, vinylidene chloride, acrylonitrile, vinyl carbazole or an acrylate or methacrylate having a polyalkylene structure and a mixture thereof. Among them, polystyrene, a copolymer containing styrene and acrylonitrile and polymethyl methacrylate are more preferred.

The average particle size of the hydrophobic thermoplastic polymer fine particle for use in the invention is preferably from 0.01 to 2.0 $\mu$m.

The thermo-reactive polymer fine particle for use in the invention includes polymer fine particle having a thermo-reactive group and forms a hydrophobilized region by crosslinkage due to thermal reaction and change in the functional group involved therein.

As the thermo-reactive group of the polymer fine particle having a thermo-reactive group for use in the invention, although a functional group performing any reaction can be used as long as a chemical bond is formed, a polymerizable group is preferred. For instance, an ethylenically unsaturated group (for example, an acryloyl group, a methacryloyl group, a vinyl group or an allyl group) performing a radical polymerization reaction, a cationic polymerizable group (for example, a vinyl group, a vinyloxy group, an epoxy group or an oxetanyl group), an isocyanate group performing an addition reaction or a blocked form thereof, an epoxy group, a vinyloxy group and a functional group having an active hydrogen atom (for example, an amino group, a hydroxy group or a carboxyl group) as the reaction partner thereof, a carboxyl group performing a condensation reaction and a hydroxyl group or an amino group as the reaction partner thereof, and an acid anhydride performing a ring opening addition reaction and an amino group or a hydroxyl group as the reaction partner thereof are preferably exemplified.

As the microcapsule for use in the invention, microcapsule having all or part of the constituting components of the image-recording layer encapsulated as described, for example, in JP-A-2001-277740 and JP-A-2001-277742 is exemplified. The constituting components of the image-recording layer may be present outside the microcapsules. It is a more preferred embodiment of the image-recording layer containing microcapsules that the hydrophobic constituting components are encapsulated in microcapsules and the hydrophilic components are present outside the microcapsules.

According to the invention, an embodiment containing a crosslinked resin particle, that is, a microgel may be used. The microgel can contain a part of the constituting components of the image-recording layer at least one of in the inside and on the surface thereof. In particular, an embodiment of a reactive microgel containing a radical polymerizable group on the surface thereof is preferred in view of the image-forming sensitivity and printing durability.

In order to conduct microencapsulation or microgelation of the constituting component of the image-recording layer, known methods can be used.

The average particle size of the microcapsule or microgel is preferably from 0.01 to 3.0 μm, more preferably from 0.05 to 2.0 μm, particularly preferably from 0.10 to 1.0 μm. In the range described above, good resolution and good time lapse stability can be achieved.
The content of the hydrophobilizing precursor is preferably in a range from 5 to 90% by weight based on the total solid content of the image-recording layer.

(G) Other components

The image-recording layer according to the invention may further contain other components, if desired.

(1) Hydrophilic low molecular weight compound

The image-recording layer according to the invention may contain a hydrophilic low molecular weight compound in order to improve the on-press development property without accompanying the decrease in the printing durability.
The hydrophilic low molecular weight compound includes a water-soluble organic compound, for example, a glycol, e.g., ethylene glycol, diethylene glycol, triethylene glycol, propylene glycol, dipropylene glycol or tripropylene glycol, or an ether or ester derivative thereof, a polyhydroxy compound, e.g., glycerine, pentaerythritol or tris(2-hydroxyethyl) isocyanurate, an organic amine, e.g., triethanol amine, diethanol amine or monoethanol amine, or a salt thereof, an organic sulfonic acid, e.g., an alkyl sulfonic acid, toluene sulfonic acid or benzene sulfonic acid, or a salt thereof, an organic sulfamic acid, e.g., an alkyl sulfamic acid, or a salt thereof, an organic sulfuric acid, e.g., an alkyl sulfuric acid or an alkyl ether sulfuric acid, or a salt thereof, an organic phosphonic acid, e.g., phenyl phosphonic acid, or a salt thereof, an organic carboxylic acid, e.g., tartaric acid, oxalic acid, citric acid, malic acid, lactic acid, gluconic acid or an amino acid, or a salt thereof and a betaine.
According to the invention, it is preferred that at least one compound selected from a polyol, an organic sulfate, an organic sulfonate and a betaine is incorporated.
Specific examples of the organic sulfonate include an alkylsulfonate, for example, sodium n-butylsulfonate, sodium n-hexylsulfonate, sodium 2-ethylhexylsulfonate, sodium cyclohexylsulfonate or sodium n-octylsulfonate; an alkylsulfonate containing an ethylene oxide chain, for example, sodium 5,8,11-trioxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-tetraoxatetracosane-1-sulfonate; an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfonate, disodium 1,5-naphtyldisulfonate or trisodium 1,3,6-naphtyltrisulfonate; and compounds described in Paragraph Nos. [0026] to [0031] of JP-A-2007-276454 and Paragraph Nos. [0020] to [0047] of JP-A-2009-154525. The salt may also be a potassium salt or a lithium salt.
The organic sulfate includes a sulfate of alkyl, alkenyl, alkynyl, aryl or heterocyclic monoether of polyethylene oxide. The number of ethylene oxide unit is preferably from 1 to 4. The salt is preferably a sodium salt, a potassium salt or a lithium salt. Specific examples thereof include compounds described in Paragraph Nos. [0034] to [0038] of JP-A-2007-276454.
As the betaine, a compound wherein a number of carbon atoms included in a hydrocarbon substituent on the nitrogen atom is from 1 to 5 is preferred. Specific examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfanate, dimethylpropylammonium methanesulfonate, 3-trimethylammonio-1-porpanesulfonate and 3-(1-pyridinio)-1-porpanesulfonate.
Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the ink receptivity and printing durability of the image-recording layer can be preferably maintained.
The amount of the hydrophilic low molecular weight compound added to the image-recording layer is preferably from 0.5 to 20% by weight, more preferably from 1 to 15% by weight, still more preferably from 2 to 10% by weight, based on the total solid content of the image-recording layer. In the range described above, good on-press development property and good printing durability are achieved.
The hydrophilic low molecular weight compounds may be used individually or as a mixture of two or more thereof

(2) Oil-sensitizing agent

In order to improve the ink receptivity, an oil-sensitizing agent, for example, a phosphonium compound, a nitrogen-containing low molecular weight compound or an ammonium group-containing polymer can be used in the image-recording layer. In particular, in the case where an inorganic stratiform compound is incorporated into an overcoat

layer, the oil-sensitizing agent functions as a surface covering agent of the inorganic stratiform compound and prevents deterioration of the ink receptivity during printing due to the inorganic stratiform compound.

As preferred examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate and 1,9-bis(triphenylphosphonio)nonane naphthalene-2,7-disulfonate.

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used. Specific examples the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyldimethyloctylammonium hexafluorophosphate, benzyldimethyldodecylammonium hexafluorophosphate and compounds described in Paragraph Nos. [0021] to [0037] of JP-A-2008-284858 and Paragraph Nos. [0030] to [0057] of JP-A-2009-90645.

The ammonium group-containing polymer may be any polymer containing an ammonium group in its structure and is preferably a polymer containing from 5 to 80% by mole of (meth)acrylate having an ammonium group in its side chain as a copolymerization component. Specific examples thereof include compounds described in Paragraph Nos. [0089] to [0105] of JP-A-2009-208458.

As to the ammonium salt-containing polymer, its reduced specific viscosity value (unit: ml/g) determined according to the measuring method described below is preferably from 5 to 120, more preferably from 10 to 110, and particularly preferably from 15 to 100. When the reduced specific viscosity value described above is calculated in terms of weight average molecular weight (Mw), from 10,000 to 150,000 is preferred, from 17,000 to 140,000 is more preferred, and 20,000 to 130,000 is particularly preferred.

<Measuring method of reduced specific viscosity>

In a 20 ml measuring flask was weighed 1 g of polymer solid content and the measuring flask is filled up to the gauge line with N-methyl pyrrolidone. The resulting solution was allowed to stand in a thermostatic bath of 30°C for 30 minutes and put into an Ubbelohde viscometer (viscometer constant: 0.010 cSt/s) and a period for running down of the solution at 30°C was measured. The measurement was conducted twice for the same sample and an average value of the measurement was determined. The measurement was also conducted for a blank (only N-methyl pyrrolidone) in the same manner. The reduced specific viscosity (ml/g) was calculated according to the formula shown below.

$$\text{Reduced specific viscosity (ml/g)} = \frac{\dfrac{\text{Period for running down of sample solution (s)} - \text{Period for running down of blank (s)}}{\text{Period for running down of blank (sec)}}}{\dfrac{3.33\ (\text{g}) \times \dfrac{30}{100}}{20\ (\text{ml})}}$$

Specific examples of the ammonium group-containing polymer are set forth below.

(1) 2-(Trimethylammonio)ethyl methacrylate p-toluenesulfonate/3,6-dioxaheptyl methacrylate copolymer (molar ratio: 10/90, Mw: 45,000)

(2) 2-(Trimethylammonio)ethyl methacrylate hexafluorophosphate /3,6-dioxaheptyl methacrylate copolymer (molar ratio: 20/80, Mw: 60,000)

(3) 2-(Ethyldimethylammonio)ethyl methacrylate p-toluenesulfonate/hexyl methacrylate copolymer (molar ratio: 30/70, Mw: 45,000)

(4) 2-(Trimethylammonio)ethyl methacrylate hexafluorophosphate /2-ethylhexyl methacrylate copolymer (molar ratio: 20/80, Mw: 60,000)

(5) 2-(Trimethylammonio)ethyl methacrylate methylsulfate/hexyl methacrylate copolymer (molar ratio: 40/60, Mw: 70,000)

(6) 2-(Butyldimethylammonio)ethyl methacrylate hexafluorophosphate/3,6-dioxaheptyl methacrylate copolymer

(molar ratio: 25/75, Mw: 65,000)

(7) 2-(Butyldimethylammonio)ethyl acrylate hexafluorophosphate/3,6-dioxaheptyl methacrylate copolymer (molar ratio: 20/80, Mw: 65,000)

(8) 2-(Butyldimethylammonio)ethyl methacrylate 13-ethyl-5,8,11-trioxa-1-heptadecanesulfonate/3,6-dioxaheptyl methacrylate copolymer (molar ratio: 20/80, Mw: 75,000)

(9) 2-(Butyldimethylammonio)ethyl methacrylate hexafluorophosphate/3,6-dioxaheptyl methacrylate/2-hydroxy-3-methacryloyloxypropyl methacrylate copolymer (molar ratio: 15/80/5, Mw: 65,000)

The content of the oil-sensitizing agent is preferably from 0.01 to 30.0% by weight, more preferably from 0.1 to 15.0% by weight, still more preferably from 1 to 10% by weight, based on the total solid content of the image-recording layer.

(3) Other components

Other components, for example, a surfactant, a coloring agent, a print-out agent, a polymerization inhibitor, a higher fatty acid derivative, a plasticizer, a fine inorganic particle, an inorganic stratiform compound, a co-sensitizer or a chain transfer agent may further be added to the image-recording layer. Specifically, compounds and amounts added thereof described, for example, in Paragraph Nos. [0114] to [0159] of JP-A-2008-284817, Paragraph Nos. [0023] to [0027] of JP-A-2006-91479 and Paragraph No. [0060] of U.S. Patent Publication No. 2008/0311520 are preferably used.

(H) Formation of image-recording layer

The image-recording layer according to the invention is formed by dispersing or dissolving each of the necessary components described above in a known solvent to prepare a coating solution and coating the solution on a support by a known method, for example, bar coater coating and drying as described, for example, in Paragraph Nos. [0142] to [0143] of JP-A-2008-195018. The coating amount (solid content) of the image-recording layer formed on the support after coating and drying may be varied according to the intended purpose but is in general preferably from 0.3 to 3.0 $g/m^2$. In the range described above, good sensitivity and good film property of the image-recording layer can be achieved.

(Undercoat layer)

In the lithographic printing plate precursor according to the invention, it is preferred to provide an undercoat layer (also referred to as an intermediate layer) between the image-recording layer and the support. The undercoat layer strengthens adhesion between the support and the image-recording layer in the exposed area and makes removal of the image-recording layer from the support in the unexposed area easy, thereby contributing improvement in the development property without accompanying degradation of the printing durability. Further, in the case of infrared laser exposure, since the undercoat layer acts as a heat insulating layer, decrease in sensitivity due to diffusion of heat generated upon the exposure into the support is prevented.

As a compound for use in the undercoat layer, a compound having an adsorbing group capable of adsorbing to a surface of support and a crosslinkable group for improving an adhesion property to the image-recording layer is preferred. Further, a compound having a hydrophilicity-imparting group, for example, a sulfo group is also exemplified as a preferable compound. The compound may be a low molecular weight compound or a polymer compound. The compounds may be used in mixture of two or more thereof, if desired.

As the polymer compound, a copolymer of a monomer having an adsorbing group, a monomer having a hydrophilic group and a monomer having a crosslinkable group is preferred. As the adsorbing group capable of adsorbing to a surface of support, a phenolic hydroxy group, a carboxyl group, $-PO_3H_2$, $-OPO_3H_2$, $-CONHSO_2-$, $-SO_2NHSO_2-$ or $-COCH_2COCH_3$ is preferred. As the hydrophilic group, a sulfo group is preferred. As the crosslinkable group, for example, a methacryl group or an allyl group is preferred.

The polymer compound may contain a crosslinkable group introduced by a salt formation between a polar substituent of the polymer compound and a compound containing a substituent having a counter charge to the polar substituent of the polymer compound and an ethylenically unsaturated bond and may also be further copolymerized with a monomer other than those described above, preferably a hydrophilic monomer.

Specifically, a silane coupling agent having an addition-polymerizable ethylenic double bond reactive group described in JP-A-10-282679 and a phosphorus compound having an ethylenic double bond reactive group described in JP-A-2-304441 are preferably exemplified. Low molecular weight compounds or polymer compounds having a crosslinkable group (preferably an ethylenically unsaturated bond group), a functional group capable of interacting with a surface of support and a hydrophilic group described in JP-A-2005-238816, JP-A-2005-125749, JP-A-2006-239867 and JP-A-2006-215263 are also preferably used.

Polymer compounds having an adsorbing group capable of adsorbing to a surface of support, a hydrophilic group and a crosslinkable group described in JP-A-2005-125749 and JP-A-2006-188038 are more preferred.
The content of the unsaturated double bond in the polymer compound for undercoat layer is preferably from 0.1 to 10.0 mmol, most preferably from 0.2 to 5.5 mmol, based on 1 g of the polymer compound.
The weight average molecular weight of the polymer compound for undercoat layer is preferably 5,000 or more, and more preferably from 10,000 to 300,000.
The undercoat layer according to the invention may contain a chelating agent, a secondary or tertiary amine, a polymerization inhibitor or a compound containing an amino group or a functional group having polymerization inhibition ability and a group capable of interacting with a surface of aluminum support (for example, 1,4-diazabicyclo[2,2,2]octane (DABCO), 2,3,5,6-tetrahydroxy-p-quinone, chloranil, sulfophthalic acid, hydroxyethylethylenediaminetriacetic acid, dihydroxyethylethylenediaminediacetic acid or hydroxyethyliminodiacetic acid) in addition to the compound for the undercoat layer described above in order to prevent the occurrence of stain due to the lapse of time.
The undercoat layer is coated according to a known method. The coating amount (solid content) of the undercoat layer is preferably from 0.1 to 100 mg/m$^2$, and more preferably from 1 to 30 mg/m$^2$.

(Support)

As the support for use in the lithographic printing plate precursor according to the invention, a known support is employed. Particularly, an aluminum plate subjected to roughening treatment and anodizing treatment according to a known method is preferred.
Also, an enlarging treatment or a sealing treatment of micropores of the anodized film described in JP-A-2001-253181 and JP-A-2001-322365 or a surface hydrophilizing treatment, for example, with an alkali metal silicate as described in U.S. Patents 2,714,066, 3,181,461, 3,280,734 and 3,902,734 or polyvinyl phosphonic acid as described in U.S. Patents 3,276,868, 4,153,461 and 4,689,272 may be appropriately selected and applied to the aluminum plate, if desired.
The support preferably has a center line average roughness of 0.10 to 1.2 μm.
The support may have a backcoat layer containing an organic polymer compound described in JP-A-5-45885 or an alkoxy compound of silicon described in JP-A-6-35174, provided on the back surface thereof, if desired.

[Plate making method]

Plate making of the lithographic printing plate precursor according to the invention is preferably performed by an on-press development method. The on-press development method includes a step in which the lithographic printing plate precursor is imagewise exposed and a printing step in which oily ink and an aqueous component are supplied to the exposed lithographic printing plate precursor without undergoing any development processing to perform printing, and it is characterized in that the unexposed area of the lithographic printing plate precursor is removed in the course of the printing step. The imagewise exposure may be performed on a printing machine after the lithographic printing plate precursor is mounted on the printing machine or may be separately performed using a platesetter or the like. In the latter case, the exposed lithographic printing plate precursor is mounted as it is on a printing machine without undergoing a development processing step. Then, the printing operation is initiated using the printing machine with supplying oily ink and an aqueous component and at an early stage of the printing the on-press development is carried out. Specifically, the image-recording layer in the unexposed area is removed and the hydrophilic surface of support is revealed therewith to form the non-image area. As the oily ink and aqueous component, printing ink and dampening water for conventional lithographic printing can be employed, respectively.
The plate making method is described in more detail below.
As the light source used for the image exposure in the invention, a laser is preferred. The laser for use in the invention is not particularly restricted and, for example, a solid laser or semiconductor laser emitting an infrared ray having a wavelength from 760 to 1,200 nm is preferably exemplified.
With respect to the infrared ray laser, the output is preferably 100 mW or more, the exposure time per pixel is preferably within 20 microseconds, and the irradiation energy is preferably from 10 to 300 mJ/cm$^2$. With respect to the laser exposure, in order to reduce the exposure time, it is preferred to use a multibeam laser device.
The exposed lithographic printing plate precursor is mounted on a plate cylinder of a printing machine. In case of using a printing machine equipped with a laser exposure apparatus, the lithographic printing plate precursor is mounted on a plate cylinder of the printing machine and then subjected to the imagewise exposure.
When dampening water and printing ink are supplied to the imagewise exposed lithographic printing plate precursor to perform printing, in the exposed area of the image-recording layer, the image-recording layer cured by the exposure forms the printing ink receptive area having the oleophilic surface. On the other hand, in the unexposed area, the uncured image-recording layer is removed by dissolution or dispersion with at least any of the dampening water and

printing ink supplied to reveal the hydrophilic surface in the area. As a result, the dampening water adheres onto the revealed hydrophilic surface and the printing ink adheres onto the exposed area of the image-recording layer, whereby printing is initiated.

While either the dampening water or printing ink may be supplied at first on the surface of lithographic printing plate precursor, it is preferred to supply the printing ink at first in view of preventing the dampening water from contamination with the component of the image-recording layer removed.

Thus, the lithographic printing plate precursor according to the invention is subjected to the on-press development on an offset printing machine and used as it is for printing a large number of sheets.

EXAMPLE

The present invention will be described in more detail with reference to the following examples, but the invention should not be construed as being limited thereto. With respect to the polymer compounds used in the examples, unless otherwise particularly defined, a molecular weight means a weight average molecular weight (Mw) and a ratio of repeating unit is indicated in mole percent.

[Examples 1 to 10 and Comparative Examples 1 to 13]

1. Preparation of Lithographic printing plate precursors (1) to (11)

(1) Preparation of Support

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm$^3$) of pumice having a median size of 25 $\mu$m, followed by thorough washing with water. The plate was subjected to etching by immersing in a 25% by weight aqueous sodium hydroxide solution of 45°C for 9 seconds, washed with water, then immersed in a 20% by weight nitric acid solution at 60°C for 20 seconds, and washed with water. The etching amount of the grained surface was about 3 g/m$^2$.

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm$^2$ in terms of the peak value of the electric current, and 5% of the electric current flowing from the electric source was divided to the auxiliary anode. The quantity of electricity in the nitric acid electrolysis was 175 C/dm$^2$ in terms of the quantity of electricity when the aluminum plate functioned as an anode. The plate was then washed with water by spraying.

The plate was further subjected to an electrochemical roughening treatment in the same manner as in the nitric acid electrolysis above using as an electrolytic solution, a 0.5% by weight aqueous hydrochloric acid solution (containing 0.5% by weight of aluminum ion) having temperature of 50°C and under the condition that the quantity of electricity was 50 C/dm$^2$ in terms of the quantity of electricity when the aluminum plate functioned as an anode. The plate was then washed with water by spraying.

The plate was then subjected to an anodizing treatment using as an electrolytic solution, a 15% by weight aqueous sulfuric acid solution (containing 0.5% by weight of aluminum ion) at a current density of 15 A/dm$^2$ to form a direct current anodized film of 2.5 g/m$^2$, washed with water and dried to prepare Support (1).

Thereafter, in order to ensure the hydrophilicity of the non-image area, Support (1) was subjected to silicate treatment using a 2.5% by weight aqueous sodium silicate No. 3 solution at 60°C for 10 seconds and then was washed with water to obtain Support (2). The adhesion amount of Si was 10 mg/m$^2$. The center line average roughness (Ra) of the support was measured using a stylus having a diameter of 2 $\mu$m and found to be 0.51 $\mu$m.

(2) Formation of Undercoat layer

Coating solution (1) for undercoat layer shown below was coated on Support (2) described above so as to have a dry coating amount of 20 mg/m$^2$ to prepare a support having an undercoat layer.

<Coating solution (1) for undercoat layer>

| | |
|---|---|
| Compound (1) for undercoat layer having structure shown below | 0.18 g |
| Hydroxyethyliminodiacetic acid | 0.10 g |
| Methanol | 55.24 g |
| Water | 6.15 g |

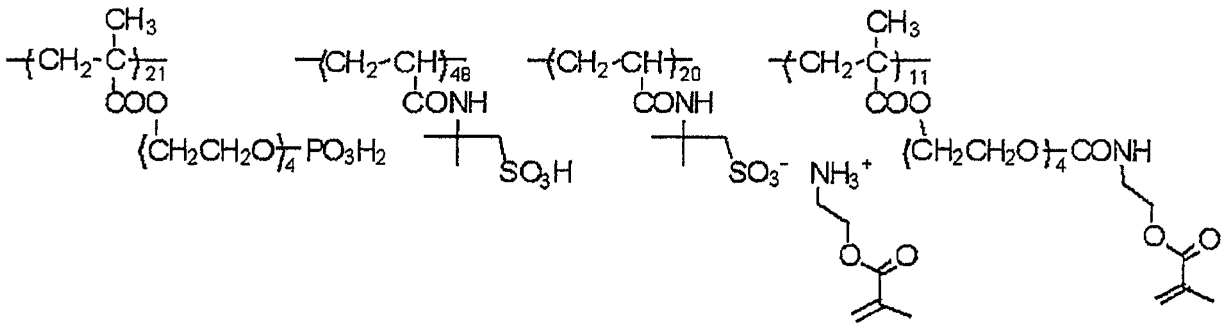

Compound (1) for undercoat layer

Mw: 100,000

(3) Formation of Image-recording layer

Coating solution (1) for image-recording layer having the composition shown below was coated on the undercoat layer formed as described above by a bar and dried in an oven at 100°C for 60 seconds to form an image-recording layer having a dry coating amount of 1.0 g/$m^2$.

Coating solution (1) for image-recording layer was prepared by mixing Photosensitive solution (1) shown below with Microgel solution (1) shown below just before the coating, followed by stirring.

<Photosensitive solution (1)>

| | |
|---|---|
| Binder polymer (2) having structure shown below | 0.240 g |
| Infrared absorbing dye (1) having structure shown below | 0.030 g |
| Radical polymerization initiator (1) having structure shown below | 0.162 g |
| Radical polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (Tris(2-hydroxyethyl) isocyanurate) | 0.062 g |
| Hydrophilic low molecular weight compound (1) having structure shown below | 0.050 g |
| Oil-sensitizing agent (Phosphonium compound (1) having structure shown below) | 0.055 g |
| Oil-sensitizing agent (Benzyl dimethyl octyl ammonium $PF_6$ salt) | 0.018 g |
| Oil-sensitizing agent (Ammonium group-containing polymer having structure shown below (reduced specific viscosity: 44 ml/g) | 0.035 g |
| Fluorine-based surfactant (1) having structure shown below | 0.008 g |
| 2-Butanone | 1.091 g |
| 1-Methoxy-2-propanol | 8.609 g |

<Microgel solution (1)>

| | |
|---|---|
| Microgel (1) | 2.640 g |
| Distilled water | 2.425 g |

The structures of Binder polymer (2), Infrared absorbing dye (1), Radical polymerization initiator (1), Phosphonium compound (1), Hydrophilic low molecular weight compound (1), Ammonium group-containing polymer and Fluorine-based surfactant (1) are shown below.

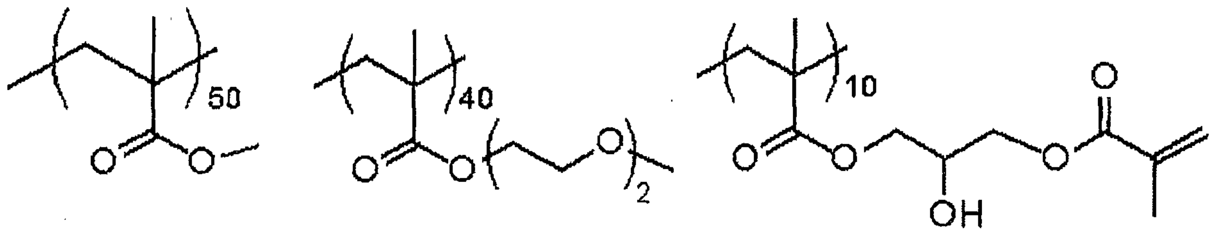

Binder polymer (2)

(Mw: 70,000)

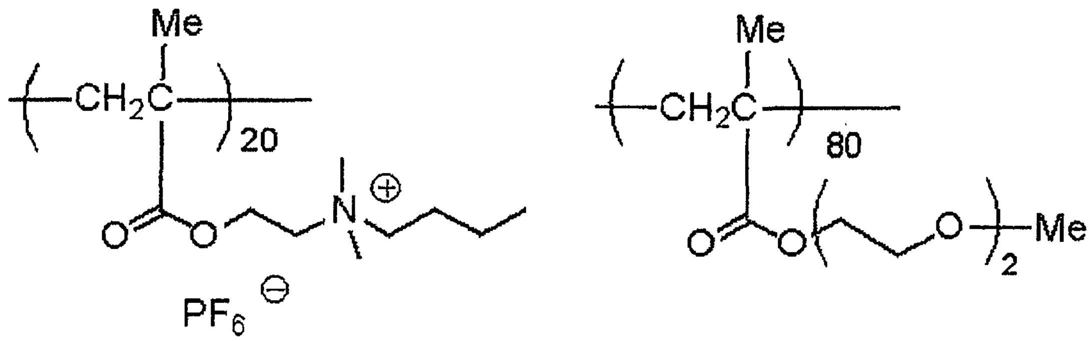

Ammonium group-containing polymer

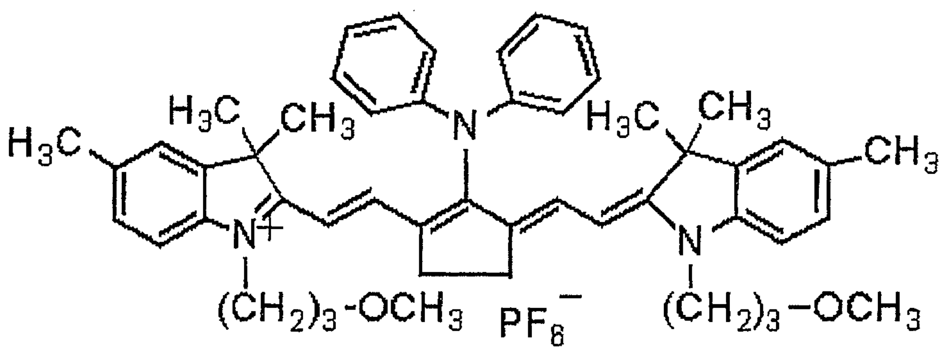

Infrared absorbing dye (1)

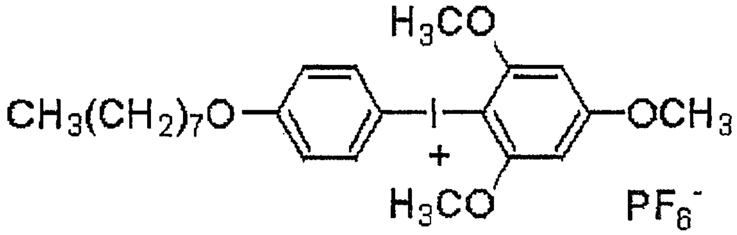

Radical polymerization initiator (1)

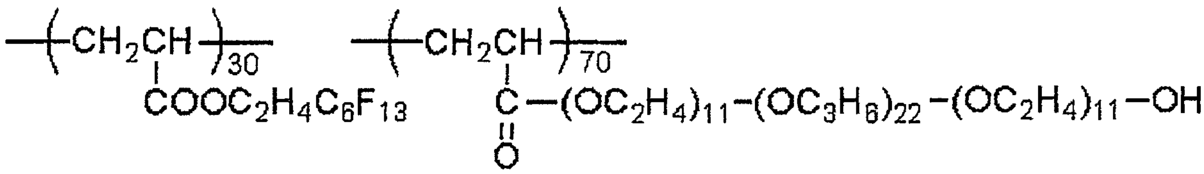

(Mw: 13,000)

Fluorine-based surfactant (1)

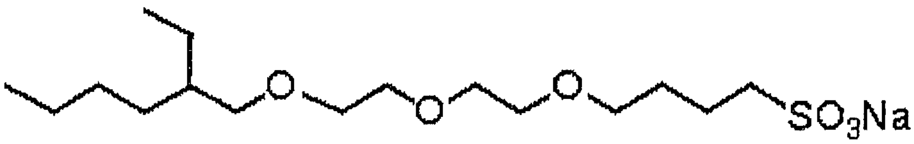

Hydrophilic low molecular weight compound (1)

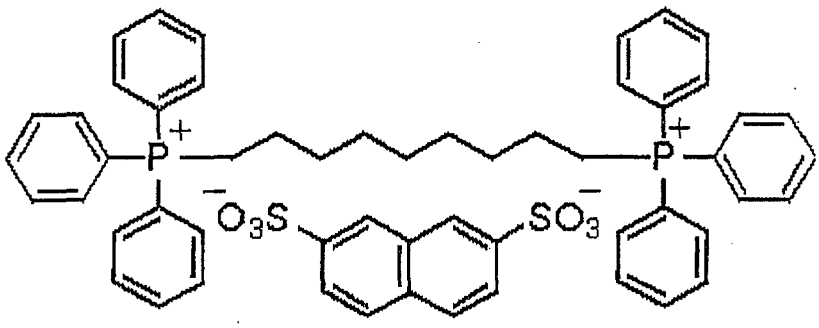

Phosphonium compound (1)

<Preparation of Microgel (1)>

An oil phase component was prepared by dissolving 10 g of adduct of trimethylol propane and xylene diisocyanate (TAKENATE D-110N, produced by Mitsui Chemicals Polyurethanes, Inc.), 3.15 g of pentaerythritol triacrylate (SR444, produced by Nippon Kayaku Co., Ltd.) and 0.1 g of PIONIN A-41C (produced by Takemoto Oil & Fat Co., Ltd.) in 17 g of ethyl acetate. As an aqueous phase component, 40 g of an aqueous 4% by weight solution of polyvinyl alcohol (PVA-205, produced by Kuraray Co., Ltd) was prepared. The oil phase component and the aqueous phase component were mixed and the mixture was emulsified using a homogenizer at 12,000 rpm for 10 minutes. The resulting emulsion was added to 25 g of distilled water and stirred at room temperature for 30 minutes and then at 50°C for 3 hours. The microgel liquid thus-obtained was diluted using distilled water so as to have the solid content concentration of 15% by weight to prepare Microgel (1). The average particle size of the microgel was measured by a light scattering method and found to be 0.2 μm.

(3) Formation of Overcoat layer

Coating solutions (1) to (11) for overcoat layer having the composition shown below were further coated on the image-recording layer described above by a bar and dried in an oven at 120°C for 60 seconds to form overcoat layers each having a dry coating amount of 0.15 g/$m^2$, thereby preparing Lithographic printing plate precursors (1) to (5) for Examples 1 to 5 and Lithographic printing plate precursors (6) to (11) for Comparative Examples 1 to 6, respectively.

<Coating solution (1) for overcoat layer>

| | |
|---|---|
| Dispersion of inorganic stratiform compound (1) | 1.5 g |
| Aqueous 6% by weight solution of hydroxyethylcellulose (SP 500, viscosity: 300 mPa·s (2% by weight), substitution degree: 1.0, produced by Daicel Chemical Industries, Ltd.) | 0.58 g |
| Aqueous 1% by weight solution of surfactant (EMALEX 710, produced by Nihon Emulsion Co., Ltd.) | 0.86 g |
| Ion-exchanged water | 6.0 g |

<Coating solution (2) for overcoat layer>

| | |
|---|---|
| Dispersion of inorganic stratiform compound (1) | 1.5 g |
| Aqueous 6% by weight solution ofhydroxypropylcellulose (HPC-SSL, viscosity: 2.0 mPa·s (2% by weight), substitution degree: 1.5 to 2.3, produced by Nippon Soda Co., Ltd.) | 0.58 g |
| Aqueous 1% by weight solution of surfactant (EMALEX 710, produced by Nihon Emulsion Co., Ltd.) | 0.86 g |
| Ion-exchanged water | 6.0 g |

<Coating solution (3) for overcoat layer>

| | |
|---|---|
| Dispersion of inorganic stratiform compound (1) | 1.5 g |
| Aqueous 6% by weight solution of hydroxyethylmethylcellulose (SEB, viscosity: 4,000 mPa·s (2% by weight), substitution degree: 1.5, produced by Shin-Etsu Chemical Co., Ltd.) | 0.58 g |
| Aqueous 1% by weight solution of surfactant (EMALEX 710, produced by Nihon Emulsion Co., Ltd.) | 0.86 g |
| Ion-exchanged water | 6.0 g |

<Coating solution (4) for overcoat layer>

| | |
|---|---|
| Dispersion of inorganic stratiform compound (1) | 1.5 g |
| Aqueous 6% by weight solution of hydroxypropylmethylcellulose (60SH, viscosity: 15 mPa·s (2% by weight), substitution degree: 1.9, produced by Shin-Etsu Chemical Co., Ltd.) | 0.58 g |
| Aqueous 1% by weight solution of surfactant (EMALEX 710, produced by Nihon Emulsion Co., Ltd.) | 0.86 g |
| Ion-exchanged water | 6.0 g |

<Coating solution (5) for overcoat layer>

| | |
|---|---|
| Aqueous 6% by weight solution of hydroxypropylcellulose (HPC-SSL, viscosity: 2.0 mPa·s (2% by weight), substitution degree: 1.5 to 2.3, produced by Nippon Soda Co., Ltd.) | 0.58 g |
| Aqueous 1% by weight solution of surfactant (EMALEX 710, produced by Nihon Emulsion Co., Ltd.) | 0.86 g |

(continued)

| | |
|---|---|
| Ion-exchanged water | 7.45 g |

<Coating solution (6) for overcoat layer>

| | |
|---|---|
| Dispersion of inorganic stratiform compound (1) | 1.5 g |
| Aqueous 6% by weight solution of carboxymethylcellulose (CMC 1105, viscosity: 50 mPa·s (5% by weight), substitution degree: 0.6 to 0.8, produced by Daicel Chemical Industries, Ltd.) | 0.58 g |
| Aqueous 1% by weight solution of surfactant (EMALEX 710, produced by Nihon Emulsion Co., Ltd.) | 0.86 g |
| Ion-exchanged water | 6.0 g |

<Coating solution (7) for overcoat layer>

| | |
|---|---|
| Dispersion of inorganic stratiform compound (1) | 1.5 g |
| Aqueous 6% by weight solution of methylcellulose (SM, viscosity: 15 mPa·s (2% by weight), substitution degree: 1.8, produced by Shin-Etsu Chemical Co., Ltd.) | 0.58 g |
| Aqueous 1% by weight solution of surfactant (EMALEX 710, produced by Nihon Emulsion Co., Ltd.) | 0.86 g |
| Ion-exchanged water | 6.0 g |

<Coating solution (8) for overcoat layer>

| | |
|---|---|
| Dispersion of inorganic stratiform compound (1) | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5 % by mole, polymerization degree: 500, produced by Kuraray Co., Ltd.) | 0.03 g |
| Aqueous 1% by weight solution of surfactant (EMALEX 710, produced by Nihon Emulsion Co., Ltd.) | 0.86 g |
| Ion-exchanged water | 6.0 g |

<Coating solution (9) for overcoat layer>

| | |
|---|---|
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5 % by mole, polymerization degree: 500, produced by Kuraray Co., Ltd.) | 0.03 g |
| Aqueous 1% by weight solution of surfactant (EMALEX 710, produced by Nihon Emulsion Co., Ltd.) | 0.86 g |
| Ion-exchanged water | 7.45 g |

<Coating solution (10) for overcoat layer>

| | |
|---|---|
| Aqueous 6% by weight solution of carboxymethylcellulose (CMC 1105, viscosity: 50 mPa·s (5% by weight), substitution degree: 0.6 to 0.8, produced by Daicel Chemical Industries, Ltd.) | 0.58 g |
| Aqueous 1% by weight solution of surfactant (EMALEX 710, produced by Nihon Emulsion Co., Ltd.) | 0.86 g |
| Ion-exchanged water | 6.0 g |

<Coating solution (11) for overcoat layer>

| | |
|---|---|
| Aqueous 6% by weight solution of methylcellulose (SM, viscosity: 15 mPa·s (2% by weight), substitution degree: 1.8, produced by Shin-Etsu Chemical Co., Ltd.) | 0.58 g |
| Aqueous 1% by weight solution of surfactant (EMALEX 710, produced by Nihon Emulsion Co., Ltd.) | 0.86 g |
| Ion-exchanged water | 6.0 g |

<Preparation of Dispersion of inorganic stratiform compound (1)>

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 μm. The aspect ratio of the inorganic particle thus-dispersed was 100 or more.

2. Preparation of Lithographic printing plate precursors (12) to (22)

Coating solution (2) for image-recording layer shown below was coated on the support having the undercoat layer described above by a bar and dried in an oven at 70°C for 60 seconds to form an image-recording layer having a dry coating amount of 0.6 g/m$^2$ and then an overcoat layer was provided on the image-recording layer in the same manner as in Lithographic printing plate precursors (1) to (11) using each of Coating solutions (1) to (11) for overcoat layer to prepare Lithographic printing plate precursors (12) to (22) for Examples 6 to 10 and Comparison Examples 7 to 12, respectively.

<Coating solution (2) for image-recording layer>

| | |
|---|---|
| Aqueous dispersion (1) of polymer fine particle | 20.0 g |
| Infrared absorbing dye (2) having structure shown below | 0.2g |
| Radical polymerization initiator (IRGACURE 250, produced by Ciba Specialty Chemicals, Inc.) | 0.5 g |
| Radical polymerizable compound (SR-399, produced by Sartomer Co.) | 1.50 g |
| Mercapto-3-triazole | 0.2 g |
| BYK 336 (produced by BYK-Chimie GmbH) | 0.4 g |
| KLUCEL M (produced by Hercules Chemical Co., Inc.) | 4.8 g |
| ELVACITE 4026 (produced by Ineos Acrylica Inc.) | 2.5 g |
| n-Propanol | 55.0 g |
| 2-Butanone | 17.0 g |

The compounds indicated using their trade names in the composition described above are shown below.
IRGACURE 250: (4-methoxyphenyl)[4-(2-methylpropyl)phenyl]iodonium hexafluorophosphate (75% by weight propylene carbonate solution)
SR-399: Dipentaerythritol pentaacrylate
BYK 336: Modified dimethylpolysiloxane copolymer (25% by weight xylene/methoxypropyl acetate solution)
KLUCEL M: Hydroxypropyl cellulose (2% by weight aqueous solution)
ELVACITE 4026: Highly branched polymethyl methacrylate (10% by weight 2-butanone solution)

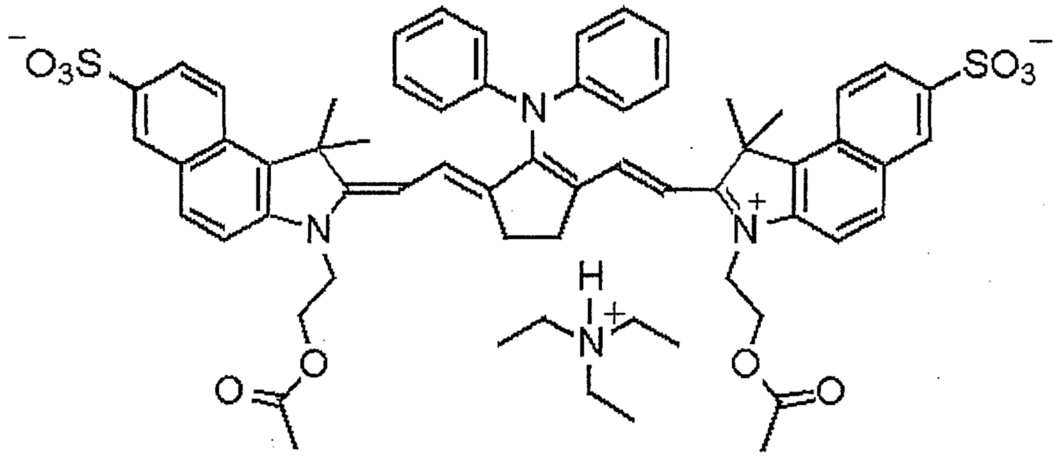

Infrared absorbing dye (2)

(Preparation of Aqueous dispersion (1) of polymer fine particle)

A stirrer, a thermometer, a dropping funnel, a nitrogen inlet tube and a reflux condenser were attached to a 1,000 ml four-neck flask and while carrying out deoxygenation by introduction of nitrogen gas, 10 g of polyethylene glycol methyl ether methacrylate (PEGMA, average repeating unit number of ethylene glycol: 50), 200 g of distilled water and 200 g of n-propanol were charged therein and heated until the internal temperature reached 70°C. Then, a mixture of 10 g of styrene (St), 80 g of acrylonitrile (AN) and 0.8 g of 2,2'-azobisisobutyronitrile previously prepared was dropwise added to the flask over a period of one hour. After the completion of the dropwise addition, the mixture was continued to react as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded 98% or more to obtain Aqueous dispersion (1) of polymer fine particle of PEGMA/St/AN (10/10/80 in a weight ratio). The particle size distribution of the polymer fine particle had the maximum value at the particle size of 150 nm.

The particle size distribution was determined by taking an electron microphotograph of the polymer fine particle, measuring particle sizes of 5,000 fine particles in total on the photograph, and dividing a range from the largest value of the particle size measured to 0 on a logarithmic scale into 50 parts to obtain occurrence frequency of each particle size by plotting. With respect to the aspherical particle, a particle size of a spherical particle having a particle area equivalent to the particle area of the aspherical particle on the photograph was defined as the particle size.

3. Preparation of Lithographic printing plate precursor (23)

Coating solution (3) for image-recording layer having the composition shown below was coated on the undercoat layer formed as described above by a bar and dried in an oven at 100°C for 60 seconds to form an image-recording layer having a dry coating amount of 1.0 g/m$^2$. Coating solution (3) for image-recording layer was prepared by mixing Photosensitive solution (3) shown below with Microgel solution (1) shown below just before the coating, followed by stirring.

Further, an overcoat layer was provided on the image-recording layer in the same manner as in Lithographic printing plate precursor (2) using Coating solution (2) for overcoat layer to prepare Lithographic printing plate precursor (23) for Comparison Example 13.

<Photosensitive solution (3)>

| | |
|---|---|
| Binder polymer (3) having structure shown below | 0.240 g |
| Infrared absorbing dye (1) | 0.030 g |
| Radical polymerization initiator (1) | 0.162 g |
| Radical polymerizable compound (Tris(acryloyloxyethyl) isocyanurate (NK ESTER A-9300, produced by Shin-Nakamura Chemical Co., Ltd.)) | 0.192 g |

(continued)

| | |
|---|---|
| Hydrophilic low molecular weight compound (Tris(2-hydroxyethyl) isocyanurate) | 0.062 g |
| Hydrophilic low molecular weight compound (1) | 0.050 g |
| Oil-sensitizing agent (Phosphonium compound (1) | 0.055 g |
| Oil-sensitizing agent (Benzyl dimethyl octyl ammonium $PF_6$ salt | 0.018 g |
| Oil-sensitizing agent (Ammonium group-containing polymer shown above(reduced specific viscosity: 44 ml/g) | 0.035 g |
| Fluorine-based surfactant (1) | 0.008 g |
| 2-Butanone | 1.091 g |
| 1-Methoxy-2-propanol | 8.609 g |

<Microgel solution (1)>

| | |
|---|---|
| Microgel (1) | 2.640 g |
| Distilled water | 2.425 g |

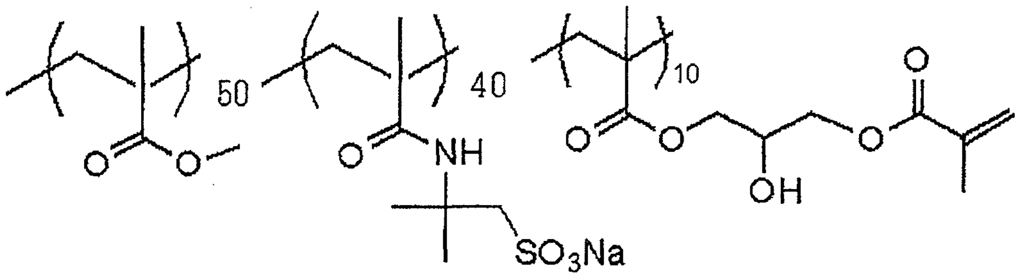

Binder polymer (3) (Mw 70,000)

4. Evaluation of Lithographic printing plate precursor

(1) On-press development property

The lithographic printing plate precursor obtained was exposed by LUXEL PLATESETTER 1-6000III equipped with an infrared semiconductor laser (produced by FUJIFILM Corp.) under the conditions of a rotational number of an external drum of 1,000 rpm, laser output of 70% and resolution of 2,400 dpi. The exposed image contained a solid image and a 50% halftone dot chart of a 20 $\mu$m-dot FM screen.

The exposed lithographic printing plate precursor was mounted without undergoing development processing on a plate cylinder of a printing machine (LITHRONE 26, produced by Komori Corp.). Using dampening water (ECOLITY-2 (produced by FUJIFILM Corp.)/tap water = 2/98 (by volume ratio)) and VALUES-G (N) Black Ink (produced by Dainippon Ink & Chemicals, Inc.), the dampening water and ink were supplied according to the standard automatic printing start method of LITHRONE 26 to conduct printing on 100 sheets of TOKUBISHI art paper (76.5 kg) at a printing speed of 10,000 sheets per hour.

A number of the printing papers required until the on-press development of the unexposed area of the image-recording layer on the printing machine was completed to reach a state where the ink was not transferred to the printing paper in the non-image area was measured to evaluate the on-press development property. The results obtained are shown in Table 1.

(2) Ink receptivity

After performing the evaluation for the on-press development property described above, the printing was continued. The 10,000th printing paper was sampled and an ink density of the 20% halftone dot of FM screen was measured using a Gretag densitometer. Based on the measured value, the ink receptivity was evaluated according the criterion shown below to obtain the results shown in Table 1.

A: Ink density from 1.8 to 1.9. The ink density did not decrease at all and good ink receptivity was exhibited.
B: Ink density from 1.5 to 1.7. The ink density somewhat decreased but it was in an acceptable level.
C: Ink density from 1.0 to 1.4. The ink density clearly decreased and it was at an unacceptable level.
D: Ink density of 0.9 or less. The ink density severely decreased and the ink receptivity was bad.

(3) Printing durability

After performing the evaluation for the on-press development property described above, the printing was continued. As the increase in a number of printing papers, the image-recording layer was gradually abraded to cause decrease in the ink density on a printed material. A number of printed materials wherein a value obtained by measuring a halftone dot area rate of the 50% halftone dot of FM screen on the printed material using a Gretag densitometer decreased by 5% from the value measured on the 100th paper of the printing was determined to evaluate the printing durability. The results obtained are shown in Table 1.

TABLE 1: Examples 1 to 10 and Comparative Examples 1 to 13

| | Lithographic Printing Plate Precursor | Coating Solution for Image-recording Layer | Coating Solution for Overcoat Layer | Evaluation Results of Printing | | |
|---|---|---|---|---|---|---|
| | | | | Ink Receptivity | On-press Development Property (sheets) | Printing Durability (x $10^4$ sheets) |
| Example 1 | 1 | (1) | (1) | A | 20 | 5 |
| Example 2 | 2 | (1) | (2) | A | 15 | 5.5 |
| Example 3 | 3 | (1) | (3) | A | 20 | 4.5 |
| Example 4 | 4 | (1) | (4) | A | 20 | 5 |
| Example 5 | 5 | (1) | (5) | A | 15 | 4 |
| Comparative Example 1 | 6 | (1) | (6) | C | 25 | 3.5 |
| Comparative Example 2 | 7 | (1) | (7) | B | 25 | 3.5 |
| Comparative Example 3 | 8 | (1) | (8) | B | 25 | 3.5 |
| Comparative Example 4 | 9 | (1) | (9) | C | 20 | 3 |
| Comparative Example 5 | 10 | (1) | (10) | C | 25 | 3.5 |
| Comparative Example 6 | 11 | (1) | (11) | B | 25 | 3.5 |
| Example 6 | 12 | (2) | (1) | A | 20 | 4.5 |
| Example 7 | 13 | (2) | (2) | A | 17 | 4.5 |
| Example 8 | 14 | (2) | (3) | A | 20 | 4 |
| Example 9 | 15 | (2) | (4) | A | 20 | 4.5 |
| Example 10 | 16 | (2) | (5) | A | 20 | 4 |
| Comparative Example 7 | 17 | (2) | (6) | B | 25 | 3.5 |
| Comparative Example 8 | 18 | (2) | (7) | C | 20 | 3 |
| Comparative Example 9 | 19 | (2) | (8) | B | 25 | 4 |

(continued)

| | Lithographic Printing Plate Precursor | Coating Solution for Image-recording Layer | Coating Solution for Overcoat Layer | Evaluation Results of Printing | | |
|---|---|---|---|---|---|---|
| | | | | Ink Receptivity | On-press Development Property (sheets) | Printing Durability (x $10^4$ sheets) |
| Comparative Example 10 | 20 | (2) | (9) | C | 20 | 4 |
| Comparative Example 11 | 21 | (2) | (10) | C | 25 | 3.5 |
| Comparative Example 12 | 22 | (2) | (11) | B | 25 | 4 |
| Comparative Example 13 | 23 | (3) | (2) | C | 25 | 3 |

INDUSTRIAL APPLICABILITY

According to the present invention, a lithographic printing plate precursor which has good on-press development property and exhibits high printing durability and good ink receptivity and a plate making method using the same are provided.

## Claims

1. A lithographic printing plate precursor of on-press development type comprising: a support; an image-recording layer containing (A) a radical polymerization initiator, (B) a radical polymerizable compound and (C) a binder polymer having an alkylene oxide group; and an overcoat layer containing (D) a water-soluble hydroxyalkylcellulose, in this order.

2. The lithographic printing plate precursor of on-press development type as claimed in Claim 1, wherein the hydroxyalkylcellulose has a hydroxyalkyl structure represented by the following formula (1):

Formula (1)

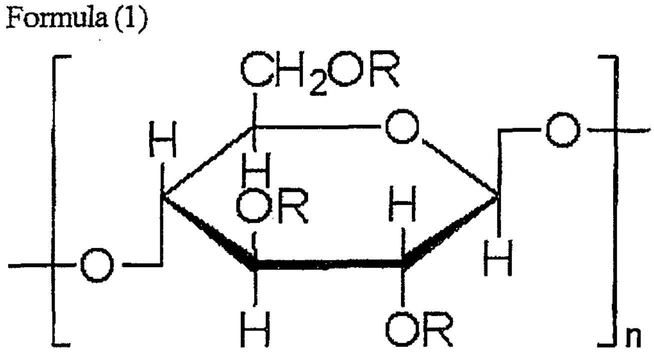

wherein in the formula (1), R represents a hydrogen atom, a methyl group or $(C_mH_{2m}O)_xH$, m represents an integer from 2 to 4, n represents an integer of 1 or more, provided that of three Rs in the formula (1), a number (substitution degree) of the $(CmH_{2m}O)_xH$ is from 0.5 to 3, and x represents an integer of 1 or more.

3. The lithographic printing plate precursor of on-press development type as claimed in Claim 2, wherein the $(C_mH_{2m}O)_xH$ in the formula (1) is $(CH_2CH(CH_3)OH)$.

4. The lithographic printing plate precursor of on-press development type as claimed in any one of Claims 1 to 3, wherein the overcoat layer contains an inorganic stratiform compound.

5. The lithographic printing plate precursor of on-press development type as claimed in any one of Claims 1 to 4, wherein the image-recording layer contains (E) an infrared absorbing dye.

6. A plate making method of performing on-press development processing by a method comprising exposing imagewise the lithographic printing plate precursor of on-press development type as claimed in any one of Claims 1 to 5, mounting the exposed lithographic printing plate precursor on a printing machine and supplying at least one of printing ink and dampening water or a method comprising mounting the lithographic printing plate precursor as claimed in any one of Claims 1 to 5 on a printing machine, exposing imagewise the lithographic printing plate precursor and supplying at least one of printing ink and dampening water.

## Patentansprüche

1. Lithographischer Druckplattenvorläufer vom auf-der-Presse-Entwicklungstyp, umfassend: einen Träger, eine Bildaufnahmeschicht, umfassend (A) einen radikalischen Polymerisationsinitiator, (B) eine radikalisch polymerisierbare Verbindung und (C) ein Bindemittelpolymer mit einer Alkylenoxidgruppe; und eine Überschicht, umfassend (D) eine wasserlösliche Hydroxyalkylcellulose, in dieser Reihenfolge.

2. Lithographischer Druckplattenvorläufer vom auf-der-Presse-Entwicklungstyp nach Anspruch 1, worin die Hydroxyalkylcellulose eine Hydroxyalkylstruktur hat, dargestellt durch die folgende Formel (1):

Formel (1)

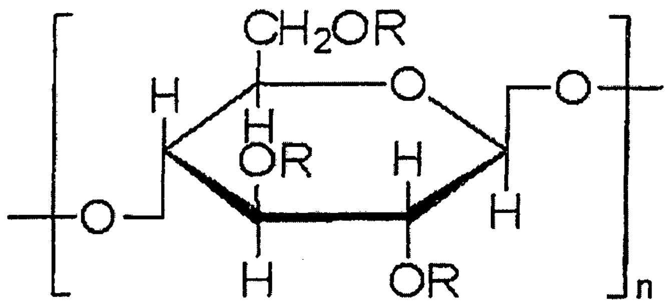

worin in der Formel (1) R ein Wasserstoffatom, eine Methylgruppe oder $(C_mH_{2m}O)_xH$ ist, m eine ganze Zahl von 2 bis 4 ist, n eine ganze Zahl von 1 oder mehr ist, vorausgesetzt, dass von drei R in der Formel (1) eine Zahl (Substitutionsgrad) von $(C_mH_{2m}O)_xH$ von 0,5 bis 3 ist; und x eine ganze Zahl von 1 oder mehr ist.

3. Lithographischer Druckplattenvorläufer vom auf-der-Presse-Entwicklungstyp nach Anspruch 2, worin $(C_mH_{2m}O)_xH$ in Formel (1) $(CH_2CH(CH_3)OH)$ ist.

4. Lithographischer Druckplattenvorläufer vom auf-der-Presse-Entwicklungstyp nach einem der Ansprüche 1 bis 3, worin die Überschicht eine anorganische Stratiformverbindung ist.

5. Lithographischer Druckplattenvorläufer vom auf-der-Presse-Entwicklungstyp nach einem der Ansprüche 1 bis 4, worin die Bildaufzeichnungsschicht (E) einen infrarotabsorbierenden Farbstoff enthält.

6. Plattenerzeugungsverfahren zur Durchführung einer Entwicklung auf der Presse durch ein Verfahren, umfassend das bildweise Belichten des lithographischen Druckplattenvorläufers vom auf-der-Presse-Entwicklungstyp nach einem der Ansprüche 1 bis 5, Befestigen des belichteten lithographischen Druckplattenvorläufers auf einer Druckmaschine und Zuführen von zumindest einer von Drucktinte und Benetzungswasser, oder ein Verfahren, umfassend das Befestigen des lithographischen Druckplattenvorläufers nach einem der Ansprüche 1 bis 5 auf einer Druckmaschine, bildweises Belichten des lithographischen Druckplattenvorläufers und Zuführen von zumindest einem von Drucktinte und Benetzungswasser.

## Revendications

1. Précurseur de plaque d'impression lithographique de type à révélation sous presse comprenant : un support ; une couche d'enregistrement d'image contenant (A) un initiateur de polymérisation radicalaire, (B) un composé polymérisable par polymérisation radicalaire et (C) un polymère de liaison ayant un groupe oxyde d'alkylène ; et une couche de finition contenant (D) une hydroxyalkylcellulose soluble dans l'eau, dans cet ordre.

2. Précurseur de plaque d'impression lithographique de type à révélation sous presse selon la revendication 1, dans lequel l'hydroxyalkylcellulose a une structure hydroxyalkyle représentée par la formule (1) suivante :

Formule (1)

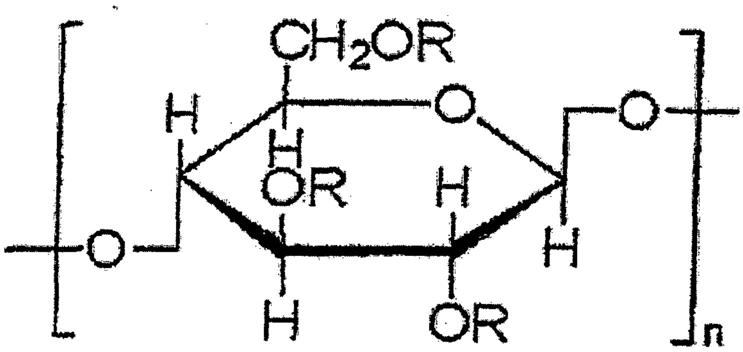

dans lequel, dans la formule (1), R représente un atome d'hydrogène, un groupe méthyle ou $(C_mH_{2m}O)_xH$, m représente un entier de 2 à 4, n représente un entier de 1 ou plus, sous réserve que parmi trois R dans la formule (1), un nombre (degré de substitution) du $(C_mH_{2m}O)_xH$ soit 0,5 à 3, et x représente un entier de 1 ou plus.

3. Précurseur de plaque d'impression lithographique de type à révélation sous presse selon la revendication 2, dans lequel le $(C_mH_{2m}O)_xH$ dans la formule (1) est $(CH_2CH(CH_3)OH)$.

4. Précurseur de plaque d'impression lithographique de type à révélation sous presse selon l'une quelconque des revendications 1 à 3, dans lequel la couche de finition contient un composé stratiforme inorganique.

5. Précurseur de plaque d'impression lithographique de type à révélation sous presse selon l'une quelconque des revendications 1 à 4, dans lequel la couche d'enregistrement d'image contient (E) un colorant absorbant les infrarouges.

6. Procédé de fabrication de plaque pour exécuter un traitement de révélation sous presse par un procédé comprenant une exposition conformément à une image du précurseur de plaque d'impression lithographique de type à révélation sous presse selon l'une quelconque des revendications 1 à 5, le montage du précurseur de plaque d'impression lithographique exposé sur une machine d'impression et la délivrance d'au moins une parmi une encre d'impression et une eau de mouillage ou un procédé comprenant le montage du précurseur de plaque d'impression lithographique selon l'une quelconque des revendications 1 à 5 sur une machine d'impression, l'exposition conformément à une image du précurseur de plaque d'impression lithographique et la délivrance d'au moins une parmi une encre d'impression et une eau de mouillage.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001277740 A
- JP 2001277742 A
- JP 2002287334 A
- JP 4162365 B
- JP 2008162056 A
- JP 2005119273 A
- JP 7021633 B
- JP 2008195018 A
- JP 8108621 A
- JP 2008019501 A
- JP 61166544 A
- JP 5158230 A
- US 4069055 A
- JP 4365049 A
- US 4069056 A
- EP 104143 A
- US 20080311520 A
- JP 2150848 A
- EP 370693 A
- EP 233567 A
- EP 297443 A
- EP 297442 A
- US 4933377 A
- US 4760013 A
- US 4734444 A
- US 2833827 A
- DE 2904626
- DE 3604580
- DE 3604581
- JP 2006508380 T
- JP 2002287344 A
- JP 2008256850 A
- JP 2001342222 A
- JP 9179296 A
- JP 9179297 A
- JP 9179298 A
- JP 2004294935 A
- JP 2006243493 A
- JP 2002275129 A
- JP 2003064130 A
- JP 2003280187 A
- JP 10333321 A
- JP 48041708 B
- JP 51037193 A
- JP 2032293 B
- JP 2016765 B
- JP 2003344997 A
- JP 2006065210 A
- JP 58049860 B
- JP 56017654 B
- JP 62039417 B
- JP 62039418 B
- JP 2000250211 A
- JP 2007094138 A
- US 7153632 B
- JP 8505958 T
- JP 2007293221 A
- JP 2007293223 A
- JP 2001133969 A
- JP 2002023360 A
- JP 2002040638 A
- JP 2002278057 A
- JP 2007090850 A
- JP 5005005 A
- JP 2001222101 A
- JP 9123387 A
- JP 9131850 A
- JP 9171249 A
- JP 9171250 A
- EP 931647 A
- JP 2007276454 A
- JP 2009154525 A
- JP 2006297907 A
- JP 2007050660 A
- JP 2008284858 A
- JP 2009090645 A
- JP 2009208458 A
- JP 2008284817 A
- JP 2006091479 A
- JP 10282679 A
- JP 2304441 A
- JP 2005238816 A
- JP 2005125749 A
- JP 2006239867 A
- JP 2006215263 A
- JP 2006188038 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 5045885 A
- JP 6035174 A

**Non-patent literature cited in the description**


- **S. I. SCHLESINGER.** *Photogr. Sci. Eng.,* 1974, vol. 18, 387
- **T. S. BAL et al.** *Polymer,* 1980, vol. 21, 423
- **J. V. CRIVELLO et al.** *Macromolecules,* 1977, vol. 10 (6), 1307
- **J. V. CRIVELLO et al.** *J. Polymer Sci., Polymer Chem. Ed.,* 1979, vol. 17, 1047
- **C. S. WEN et al.** *Teh, Proc. Conf. Rad. Curing ASIA,* October 1988, 478
- Senryo Binran. The Society of Synthetic Organic Chemistry, 1970